# EUROPÄISCHE PATENTSCHRIFT

(11) **EP 4 359 805 B1**
(45) Veröffentlichungstag und Bekanntmachung des Hinweises auf die Patenterteilung: **15.04.2026**
(21) Anmeldenummer: 22735178.0
(22) Anmeldetag: 24.06.2022
(51) Int. Cl.: G01R 1/20

(54) **STROMSCHIENE ZUR STROMMESSUNG EINES GLEICH- UND/ODER WECHSELSTROMS**
BUSBAR FOR MEASURING A DIRECT AND/OR ALTERNATING CURRENT
BARRE OMNIBUS POUR MESURER UN COURANT CONTINU ET/OU ALTERNATIF

(30) Priorität: 24.06.2021 DE 102021116419
(43) Veröffentlichungstag der Anmeldung: 01.05.2024
(73) Patentinhaber: SMA Solar Technology AG, 34266 Niestetal (DE)
(72) Erfinder: MUEHLHAUSEN, Felix, 34123 Kassel (DE)
(86) Internationale Anmeldenummer: PCT/EP2022/067415
(87) Internationale Veröffentlichungsnummer: WO 2022/269069

(56) Entgegenhaltungen:
- EP-A1- 3 671 225
- DE-A1- 2 939 594
- GB-A- 2 259 783

## Beschreibung

### TECHNISCHES GEBIET DER ERFINDUNG

Die Anmeldung betrifft eine Stromschiene zur Strommessung eines elektrischen Gleich- und/oder Wechselstroms, insbesondere mit Stromstärken größer als 100 Ampere, eine Vorrichtung zur Stromermittlung sowie einen elektrischen Leistungswandler mit einer Vorrichtung zur Stromermittlung.

### STAND DER TECHNIK

Eine Stromschiene ist eine Vorrichtung aus elektrisch leitendem Material zur Leitung elektrischer Ströme zwischen Anschlussbereichen der Stromschiene.

Für eine präzise Ermittlung elektrischer Ströme, insbesondere hoher Ströme im Bereich einiger Hundert Ampere bis zu einigen Kiloampere, können niederohmige Messwiderstände, sogenannte Shunts verwendet werden. Bei Shunts werden Messabgriffe üblicherweise in den Anschlussbereichen beidseitig direkt neben einem Widerstandsmaterial kontaktiert. Das Widerstandsmaterial des Shunts unterscheidet sich vom übrigen Material des Shunts insbesondere durch einen (leicht) erhöhten spezifischen Widerstand und zeichnet sich z. B. durch einen auch über große Temperaturbereiche konstanten Widerstandswert des elektrischen Widerstandes aus.

Beispielsweise ist aus der DE 10 2016 010 012 B4 eine Messanordnung zur Messung eines Stroms bekannt, bei der Paare von Spannungsabgriffen als Messkontakte eine über ein Widerstandsmaterial abfallende Spannung messen, wobei eine Messschaltung anhand des ohmschen Gesetzes aus der abfallenden Spannung und dem Widerstandswert des Widerstandsmaterials ein Maß für den das Widerstandmaterial durchfließenden elektrischen Strom ermittelt.

In der DE 10 2013 005 939 A1 wird die Problematik eines Phasenfehlers bei Shunts im Hochstrombereich beschrieben. Die dort beschriebene Lösung zur Vermeidung eines Phasenfehlers umfasst eine mehrfache Spannungsmessung an unterschiedlichen Positionen am Shunt und gewichtete Mittelwertbildung mit dynamischen Gewichtungsfaktoren.

In der DE 10 2020 111 634 B3 wird ein Shunt mit dezidiertem Widerstandsmaterial und Paaren von Abgriffen beschrieben, wobei ein Abgriff (einseitig) von einem Einschnitt umgeben ist, der einen Stromfluss quer über den Einschnitt verhindert.

Aus der DE 2 939 594 A1 ist ein Messwiderstand bekannt, der aus einem Teil aus Widerstandsmaterial besteht, z.B. Manganin oder Isotan, und zwei Anschlüsse zum Abgriff eines Spanungsabfalls über einen Teil der Widerstandsstrecke des Messwiderstands aufweist, wobei die Enden des Messwiderstandes abgeflacht und verbreitert sind und als Hochstromanschlüsse fungieren.

In der GB 2 259 783 B ist ein Shunt offenbart, der aus einer Kupferlegierung (Manganin) besteht und zwei Endbereiche mit größerem Querschnitt sowie einen Mittelbereich mit geringerem Querschnitt aufweist, wobei zwei Messabgriffe im Mittelbereich angeordnet sind und über eine Twisted-Pair-Leitung mit einer Leiterplatte verbunden sind.

Aus der EP 3 671 225 A1 ist ein Widerstand bekannt, der außenliegende Anschlussbereiche aus Kupfer und einen mittig dazwischen angeordneten Streifen aus einem Material mit etwa 10-mal höherem spezifischen Widerstand aufweist, z.B. aus einer Kupfer-Nickel-Mangan-Legierung, wobei beidseits des Streifens Messkontakte und Schlitze so angeordnet sind, dass die Stromdichte am Ort der Messkontakte reduziert ist, um die Abweichung einer über die Messkontakte abfallenden Messspannung bei unterschiedlichen Temperaturen zu reduzieren.

Als Spannungsabgriff kann ein Einpresspin verwendet werden, der in eine Einpressbohrung im Shunt eingepresst ist. Ein solcher Einpresspin innerhalb einer Einpressbohrung in einem stromdurchflossenen Bereich eines Shunts wirkt als Spannungsteiler zwischen den unterschiedlichen Potentialen auf den gegenüberliegenden Seiten der Einpressbohrung. Wenn sich z.B. aufgrund von mechanischen Einwirkungen die Übergangswiderstände an den unterschiedlichen Seiten der Einpressverbindung ändern, hat dies eine Veränderung des Spannungsteilers zur Folge. Hierdurch ändert sich die effektive Position des Einpresspins und damit der effektive Abstand zwischen zwei Messkontakten, auch Messpunkte genannt, über die bei der Shunt-Strommessung der Spannungsabfall gemessen wird. Ein typischer Durchmesser der Einpressbohrungen liegt bei metallischen Werkstücken z.B. bei 1 mm. Bei einer Abgrifflänge, d.h. einem nominellen Abstand zwischen zwei Messkontakten von z.B. 20 mm kann der effektive Abstand zwischen den effektiven Positionen der Spannungsabgriffe an den jeweiligen Außenseiten der Einpressbohrungen zwischen 19 mm und 21 mm betragen, d.h. es können sich um bis zu 10 % unterschiedliche Messwerte bei ansonsten gleichen elektrischen Randbedingungen ergeben.

Bei Shunt-Strommessungen werden Shunts im Bereich einiger Mikroohm eingesetzt, um die Verlustleistung in einem akzeptablen Bereich zu halten. Um derart niedrige Messwiderstände zu erreichen müssen Widerstandslegierungen mit hohen Leitfähigkeiten und großen Querschnitten eingesetzt werden. Bei einem Nennstrom im Bereich einiger Hundert Ampere können daraus zu messende Spannungsabfälle im Bereich weniger Millivolt resultieren.

Bei der AC-Strommessung mit Shunt-Widerständen mit großen Abmessungen können zudem aufgrund von Skin-Effekten und Induktion erhebliche Phasenfehler auftreten. Die Phasenfehler, die bei der Shunt-Strommessung auftreten können, werden im Wesentlichen hervorgerufen durch Induktionsspannungen innerhalb der Messleitungen (je nach Verlegung der Messleitungen) und durch den Skin-Effekt, der bei Wechselstrom zu einer positionsabhängigen Phasenlage der Stromdichte innerhalb des Shunts führt. Der Skin Effekt ruft dabei nicht nur eine frequenz- und positionsabhängige Amplitude, sondern auch eine frequenz- und positionsabhängige Phase hervor, wobei letztere in der Anwendung häufig deutlich signifikanter auffällt. Induktionsspannungen werden in den Messleitungen zwischen dem Shunt und der Auswerteeinheit hervorgerufen, wenn die Messleitungen mit dem Shunt eine Fläche aufspannen, die vom zeitvarianten Magnetfeld des Laststroms durchsetzt wird. Dieser Effekt tritt bei Hochstrom-Shunts in einer deutlich messbaren Größenordnung auf, weil im Vergleich zu üblichen Shunt-Strommessungen im niedrigen Ampere-Bereich die Magnetfelder linear mit dem Strom wachsen und deren Einfluss linear mit der Verringerung der Messspannung zunimmt. Die Kombination aus diesen beiden Effekten bedingt, dass induktive Einflüsse auch bei niedrigen Frequenzen im Bereich der Netzfrequenz und deren einstelligen Harmonischen einen messbaren Einfluss haben, der sich hauptsächlich in einem frequenzabhängigen Phasenfehler widerspiegelt. Beispielsweise können zur AC-Strommessung am Ausgang einer Wechselrichterbrücke Manganin-Shunts mit aufgelöteten Messleiterplatten eingesetzt werden, die einen Phasenfehler von etwa 3 Grad bei Netzfrequenz und einen Phasenfehler von etwa 12 Grad im Bereich einer aktiv geregelten Harmonischen, z.B. bei 250 Hz aufweisen. Bei Verwendung schnell schaltender Leistungshalbleiter ist jedoch eine phasenrichtige Messung der Wechselströme zur Regelung von Oberschwingungen bei hohen Frequenzen notwendig. Bei der Verwendung von Shunts aus Widerstandsmaterialien, die einen signifikanten Temperaturkoeffizienten des spezifischen Widerstands aufweisen, ist der frequenzabhängige Phasenfehler zudem auch von der Temperatur abhängig, sodass eine digitale Frequenzgangkompensation aufwändig wäre.

### AUFGABE DER ERFINDUNG

Der Erfindung liegt die Aufgabe zugrunde, eine Stromschiene zur Strommessung bereitzustellen, die eine möglichst gute Messung bei möglichst einfachem und/oder preisgünstigem Aufbau ermöglicht.

### LÖSUNG

Die Aufgabe wird durch eine Vorrichtung zur Stromermittlung mit einer Stromschiene mit den Merkmalen des Patentanspruchs 1 gelöst. Bevorzugte Ausführungsformen sind in den abhängigen Patentansprüchen beansprucht.

### BESCHREIBUNG

Eine Stromschiene zur Strommessung eines Gleich- und/oder Wechselstroms, insbesondere mit Stromstärken größer als Hundert Ampere, weist Anschlussbereiche und mindestens einen zwischen den Anschlussbereichen angeordneten Widerstandsbereich auf. Im Widerstandsbereich sind zwei Messkontakte angeordnet. Dabei ist die Stromschiene einstückig ausgebildet und weist eine Geometrie auf, bei der die Bereiche der Messkontakte während des Betriebs der Stromschiene im Wesentlichen stromlos sind.

Die Stromschiene weist zwei Anschlussbereiche sowie einen zwischen den Anschlussbereichen liegenden Widerstandsbereich mit einer im Wesentlichen ebenen Oberfläche auf. Der Widerstandsbereich stellt somit eine elektrische und eine mechanische Verbindung zwischen den Anschlussbereichen her.

Bei einer solchen einstückig ausgebildeten Stromschiene zur Strommessung, welche aus Kupfer oder Aluminium besteht, wird die Geometrie der Stromschiene und insbesondere die Geometrie des Widerstandsbereiches so gewählt, dass die Bereiche der Messkontakte stromlos sind, während der überwiegende Teil des Widerstandsbereichs den Arbeitsstrom führt und während des Betriebs beispielsweise in einem Leistungswandler von einigen Hundert Ampere oder gar einigen Kiloampere durchflossen wird. Dieser durch die Stromschiene fließende Arbeitsstrom kann durch Messung der Spannung bzw. der Spannungsdifferenz zwischen den zwei Messkontakten unter Verwendung des Widerstandswertes des Widerstandsbereiches zwischen den zwei Messkontakten ermittelt werden. Die weitgehend stromlosen Bereiche der Messkontakte ermöglichen dabei eine genauere Messung, insbesondere indem die Messung toleranter gegenüber etwaigen Verschiebungen der konkreten Position eines Messkontaktes ist. Außerdem kann eine hohe Homogenität der Stromdichte im stromführenden Bereich des Widerstandsbereiches erzielt werden.

Durch die einstückige Ausführung der Stromschiene kann ein einfacherer und kostengünstigerer Aufbau erreicht werden und z. B. eine Fertigung der Stromschiene mit integriertem Widerstandsbereich und stromlosen Messkontaktbereichen vereinfacht werden. Außerdem könnten Probleme bei den Übergängen zwischen verschiedenen Materialen vermieden werden.

Die Stromschiene zur Strommessung weist eine sogenannte Stromschatten-Geometrie auf. Dies basiert auf der Idee, die Messabgriffe nicht im stromführenden Bereich einer Stromschiene zu platzieren, sondern in einem Teil der Stromschiene, der speziell dafür geschaffen ist und so ausgebildet ist, nicht oder nur sehr schwach vom letztlich zu messenden Strom durchflossen zu werden. Hierfür sind unterschiedliche Geometrien denkbar.

In der Erfindung wird der Widerstandsbereich im Wesentlichen durch eine Verjüngung des Querschnitts gegenüber dem Querschnitt der Anschlussbereiche der Stromschiene gebildet, wobei sich die Messkontakte innerhalb der Querschnittsverjüngung befinden. Die Verjüngung wird hierbei insbesondere durch eine Reduzierung der Breite des Widerstandsbereiches auf einen Wert zwischen 10 und 60 Prozent der Breite der Anschlussbereiche der Stromschiene gebildet. Dadurch kann eine höhere Stromdichte im Widerstandsbereich als in den Anschlussbereichen der Stromschiene erzielt werden, die wiederum einen höheren Spannungsabfall bei einem gegebenen durch die Stromschiene fließenden Strom bewirkt. Etwaige damit verbundenen höhere Verluste im Widerstandsbereich werden dabei zugunsten der Anhebung des Spannungsabfalls in einen gut messbaren Bereich in Kauf genommen.

Eine solche lokal erhöhte Stromdichte kann mit einer erhöhten Temperatur im Widerstandsbereich einhergehen. Optional kann dieser Effekt jedoch durch eine Temperaturkompensation anhand der für den Widerstandsbereich repräsentativen Temperaturmessung neutralisiert und durch eine Eingrenzung auf einen lokal begrenzten und gut definierten Messbereich überkompensiert werden.

Bei der einstückigen Stromschiene zur Strommessung mit Querschnittsverjüngung als Widerstandsbereich befinden sich die Messkontakte im Widerstandsbereich innerhalb der Querschnittsverjüngung. Dabei ist der Widerstandswert des Widerstandsbereichs temperaturabhängig. Ein an dem Widerstandselement angeordneter Temperaturfühler hat deshalb den Vorteil, dass die gemessene Temperatur verwendet werden kann, um einen kalibrierten Widerstandswert des Widerstandsbereiches zu ermitteln, der im Folgenden mit dem gemessenen Spannungsabfall zwischen den Messkontakten verrechnet wird, um den Strom zu ermitteln.

Insbesondere wenn das Widerstandselement aus einem gängigen Material besteht, das eine sehr gute Leitfähigkeit aufweist, beispielsweise Kupfer, dessen spezifischer Widerstand jedoch stark temperaturabhängig ist, ist es vorteilhaft, die Temperatur des Widerstandsmaterials genau dort zu messen, wo auch der relevante Spannungsabfall stattfindet. Diesen Vorteil bietet die Anordnung des Temperaturfühler zwischen den Messkontakten.

In einer Ausführungsform weist die Stromschiene eine Längs-Mittelachse auf, die in Längsrichtung der Stromschiene von einem der Anschlussbereiche zum gegenüberliegenden Anschlussbereich durch den Widerstandsbereich verläuft, wobei die Messkontakte im Bereich der Längs-Mittelachse angeordnet sind und wobei die Stromschiene zumindest zwischen den jeweiligen Anschlussbereichen im Wesentlichen symmetrisch zu der Längs-Mittelachse ist. Die Stromschiene zur Strommessung weist somit eine Stromschatten-Geometrie mit mittig auf einer entlang der Fließrichtung des Stromes liegenden Längs-Mittelachse liegenden Messabgriffen auf. Diese weisen eine hohe Robustheit gegenüber mechanischen Einflüssen sowie externen Magnetfeldern auf und können deshalb gut reproduzierbare Ergebnisse liefern. In einer Ausführungsform ist die Stromschiene zumindest zwischen den jeweiligen Anschlussbereichen im Wesentlichen symmetrisch zu einer Quer-Mittelachse ausgebildet, wobei die Quer-Mittelachse in Querrichtung der Stromschiene mittig zwischen den Anschlussbereichen verläuft, und wobei die Messkontakte im Wesentlichen symmetrisch zur Quer-Mittelachse angeordnet sind.

In der Erfindung weist die Geometrie der Stromschiene im Widerstandsbereich zumindest zwei Aussparungen auf, welche im Bereich der Messkontakte angeordnet und in Längsrichtung von den Messkontakten beabstandet sind, wobei insbesondere im Bereich jedes Messkontaktes eine Aussparung angeordnet ist. Die Aussparungen sind dabei so angeordnet, dass der Bereich der Messkontakte weitgehend stromlos ist, indem die Aussparungen in Stromflussrichtung gesehen insbesondere vor bzw. hinter den Messkontakten angeordnet sind. Der Bereich des Widerstandsbereiches außerhalb der Bereiche der Messkontakte kann dabei als stromführender oder stromdurchflossener Bereich bezeichnet werden.

In der Erfindung ist zwischen den Messkontakten mindestens ein Temperaturfühler, insbesondere im Bereich der Längs-Mittelachse und/oder der Quer-Mittelachse, angeordnet. Ein einzelner Temperaturfühler kann bevorzugt auf der Längs-Mittelachse und der Quer-Mittelachse angeordnet sein. Alternativ können beispielsweise zwei Temperaturfühler auf der Quer-Mittelachse und im Wesentlichen symmetrisch um die Längs-Mittelachse angeordnet sein. Die Messkontakte können im Wesentlichen symmetrisch zur Quer-Mittelachse bzw. um den oder die Temperaturfühler angeordnet sein.

In einer Ausführungsform der Stromschiene ist zwischen den Messkontakten zumindest eine Aussparung angeordnet, wobei die Aussparung zwischen den Messkontakten angeordnet und insbesondere im Wesentlichen symmetrisch ausgebildet ist und die Längs-Mittelachse und/oder die Quer-Mittelachse als Symmetrieachse aufweist.

In einer Ausführungsform der Stromschiene bildet die Längs-Mittelachse eine Symmetrieachse einer oder mehrerer Aussparungen. Alternativ oder zusätzlich können zumindest zwei Aussparungen im Wesentlichen symmetrisch zur Quer-Mittelachse angeordnet sein.

In einer Ausführungsform der Stromschiene ist in Stromflussrichtung auf zwei Seiten jedes Messkontaktes jeweils eine Aussparung angeordnet, wobei die Aussparungen entlang der Längs-Mittelachse und/oder entlang der Quer-Mittelachse im Wesentlichen symmetrisch zu dem jeweiligen Messkontakt ausgebildet sind. Die Aussparungen können hierbei insbesondere im Wesentlichen punktsymmetrisch zu dem Messkontakt und/oder im Wesentlichen achsensymmetrisch zu einer durch den Messkontakt laufenden Achse sein. Insbesondere können die Aussparungen im Wesentlichen achsensymmetrisch zu der durch den jeweiligen Messkontakt verlaufenden Längs-Mittelachse sein.

In einer Ausführungsform der Stromschiene weisen die jeweiligen Bereiche der Messkontakte jeweils ein Messpunktplateau und jeweilige Verbindungsstege auf, wobei die Messkontakte auf dem jeweiligen Messpunktplateau angeordnet sind. Die jeweiligen Messpunktplateaus sind über die jeweiligen Verbindungsstege mit dem stromführenden Bereich des Widerstandsbereichs verbunden, wobei die Verbindungsstege bevorzugt quer zur Längs-Mittelachse verlaufen. Die Verbindungsstege werden insbesondere durch die Aussparungen begrenzt. Über die Verbindungsstege liegt das Messpunktplateau auf einem Potential, das dem Potential an den Schnittstellen der Verbindungsstege mit dem stromführenden Bereich des Widerstandsbereichs entspricht, so dass die Spannungsdifferenz zwischen den Messkontakten im Wesentlichen der Spannungsdifferenz zwischen diesen Schnittstellen entspricht. Zugleich ist die Geometrie mit Messpunktplateau und Verbindungsstegen so ausgebildet, dass der Arbeitsstrom, der parallel zur Längs-Mittelachse durch die stromführenden Bereiche fließt, nicht über die parallel zur Quer-Mittelachse orientierten Verbindungsstege und das Messpunktplateau fließt. Das Messpunktplateau und die Verbindungsstege - und damit der Bereich der Messkontakte - sind dadurch weitgehend stromlos.

In einer Ausführungsform der Stromschiene weisen die Verbindungsstege eine Breite zwischen zwei und fünf Millimetern auf und die Messpunktplateaus weisen eine Längsausdehnung zwischen fünf und zwölf Millimetern auf. Die Breite der Verbindungsstege bezieht sich dabei auf ihre Ausdehnung senkrecht zu der Richtung, in der sie ihr jeweiliges Messpunktplateau mit dem stromführenden Bereich des Widerstandsbereiches verbinden. Bevorzugt verlaufen die Verbindungsstege dabei parallel zur Quer-Mittelachse und insbesondere symmetrisch auf gegenüberliegenden Seiten des jeweiligen Messpunktplateaus und verbinden das Messpunktplateau mit dem stromführenden Bereich der Stromschiene. Die Längsausdehnung der Messpunktplateaus bezieht sich auf ihre Ausdehnung in Richtung der Verbindungsstege und/oder in einer Richtung senkrecht zur Richtung der Verbindungsstege. In einer Ausführungsform der Stromschiene sind jeweils beidseits der Messpunktplateaus und der Verbindungsstege Aussparungen angeordnet, welche von der Längs-Mittelachse bevorzugt mittig durchschnitten werden und die in Richtung der Längs-Mittelachse jeweils eine Breite zwischen zwei und zehn mm aufweisen.

In einer Ausführungsform der Stromschiene beträgt die Materialstärke des Widerstandsbereichs und/oder der Anschlussbereiche zwischen zwei und sechs Millimeter. Die Materialstärke entspricht dabei einer Dicke der Stromschiene im Widerstandsbereich und in den Anschlussbereichen. Der Querschnitt des Widerstandsbereich kann dabei als eine Fläche betrachtet werden, die die Breite des Widerstandsbereiches und die Dicke der Stromschiene als Seitenlängen aufweist.

Die Stromschiene kann für die Durchleitung von Strömen ausgelegt sein, deren Stromstärke mehr als 100 Ampere, bevorzugt mehr als 1000 Ampere beträgt. Dabei ist die Stromschiene einstückig, aus Kupfer oder Aluminium ausgebildet, wobei der Widerstandsbereich im Wesentlichen durch eine Verjüngung des Querschnitts gegenüber dem Querschnitt der Anschlussbereiche der Stromschiene gebildet wird. Dadurch werden Materialübergänge vermieden und der Herstellungs- und Montageaufwand verringert. Insbesondere bei der Nutzung von Stromschienen aus Kupfer kann eine erhebliche Kostenersparnis erzielt werden, da Shunts mit einem Widerstandsbereich aus speziellem Widerstandsmaterial, z. B. Manganin, deutlich teurer sein können. Alternativ oder zusätzlich können die Aussparungen gestanzt sein. Dadurch kann der Herstellungs- und Montageaufwand weiter verringert werden.

In einer Ausführungsform der Stromschiene sind die Messkontakte als Einpressstifte, auch Einpresspins genannt, ausgeführt, die in Einpressbohrungen in der Stromschiene eingepresst sind. Hierdurch können Messabweichungen durch z. B. Einbautoleranzen oder Alterung minimiert werden. Außerdem kann die Montage kostengünstiger realisiert werden. Die Messkontakte können wahlweise auch als Federkontakte, als Lötverbindungen oder als Schraubverbindungen mit der Stromschiene ausgeführt sein. Hierdurch kann die Kontaktierung von Messkontakten auf der Stromschiene, die für hohe Ströme ausgelegt ist, technisch vereinfacht werden. Insbesondere können Ungenauigkeiten der Positionierung der Messkontakte, welche zu Messfehlern führen können, vermieden werden.

Durch mechanische Einwirkungen können die Übergangswiderstände zwischen einem Einpressstift und der Stromschiene beeinflusst werden. Es ist deshalb vorteilhaft, die Einpresskontakte in einem weitgehend stromlosen Bereich der Stromschiene anzuordnen, so dass ein Spannungsabfall entlang des Einpresspins und insbesondere entlang der endlichen Breite der Einpressbohrungen minimiert ist. Dadurch kann ein Potenzialunterschied bzw. Spannungsabfall zwischen gegenüberliegenden Seiten einer Einpressbohrung in der Stromschiene soweit minimiert werden, dass er messtechnisch nicht mehr relevant ist, ob der Einpresskontakt je nach mechanischer Belastung mal die eine und mal die andere Seite der Einpressbohrung kontaktiert. Dadurch kann auch die Langzeitstabilität der Messung deutlich verbessert werden. Messabweichungen können dadurch minimiert werden, sogar wenn sich der Messkontakt mechanisch ein wenig verschiebt oder sich die elektrischen Eigenschaften verändern.

Die Vorrichtung zur Stromermittlung in der Erfindung weist eine Stromschiene und eine planparallel zu der Stromschiene angeordnete Leiterplatte zur Messwerterfassung auf. Dabei liegt die Leiterplatte planparallel auf der Stromschiene auf. Die Messwerterfassung umfasst eine Erfassung einer Spannungsdifferenz zwischen zwei Messkontakten eines Widerstandsbereichs und optional eine Temperaturerfassung über den Temperaturfühler des entsprechenden Widerstandsbereichs. Dabei können die Messkontakte über Messleitungen mit einem gemeinsamen Abgriffpunkt verbunden werden, an dem beispielsweise ein Spannungssensor angeordnet ist, der die Spannung zwischen den Endpunkten der Messleitungen am gemeinsamen Abgriffpunkt erfasst. Dabei können die Messleitungen in einer Ebene der Leiterplatte verlaufen, die als äußerste Innenlage der Leiterplatte auf der dem Widerstandsbereich zugewandten Seite der Leiterplatte angeordnet ist, und/oder ganz oder teilweise in anderen Ebenen bzw. Lagen der Leiterplatte verlaufen

Hierdurch ist es möglich, die Verbindungen zwischen den Messkontakten und der Auswerteeinheit sehr dicht am Widerstandsbereich anzuordnen, insbesondere um Leiterschleifen zu vermeiden. Leiterschleifen können insbesondere in der Nähe von hohen Strömen aufgrund elektromagnetischer Effekte zu erheblichen Beeinträchtigungen oder Verfälschungen der Messung führen, vor allem wenn die Ströme periodische oder transiente Anteile enthalten.

Die Leiterplatte kann den Temperatürfühler umfassen und derart im Widerstandsbereich auf der Oberfläche der Stromschiene angeordnet sein, dass der Temperaturfühler in thermischer Verbindung mit dem Widerstandsbereich der Stromschiene angeordnet ist. Dabei sind die Messkontakte, die die Oberfläche der Stromschiene elektrisch kontaktieren, z. B. beiderseits des Temperaturfühlers angeordnet und mit den Messleitungen verbunden, um mittels eines geeigneten Spannungsmessers auf der Leiterplatte eine Spannungsdifferenz entlang des Widerstandsbereichs zu erfassen.

In einer Ausführungsform der Vorrichtung liegt die Leiterplatte flächig auf Stromschiene auf, so dass die Messkontakte auf kürzestem Weg elektrischen Kontakt zwischen der Oberfläche der Stromschiene und den Messleitungen in der Leiterplatte herstellt und der Temperaturfühler auf der Oberfläche des Shunt aufliegt. So kann eine Strommessung mit hoher Genauigkeit erreicht werden.

In einer Ausführungsform der Vorrichtung erfolgt die Messwerterfassung über Messleitungen, welche so als Leiterbahnen innerhalb der Leiterplatte verlegt sind, dass frequenzabhängige Phasen- und Amplitudenmessfehler reduziert werden. Die Messleitungen zur Verbindung der Messkontakte mit einer Auswerteeinheit, insbesondere einem Spannungsmesser, können als Leiterbahnen innerhalb einer Leiterplatte derart entlang einer Bahn relativ zur Oberfläche der Stromschiene verlegt werden, dass der Phasen- und Amplitudenfehler im Vergleich zu einer klassischen Verlegung der Messleitungen, beispielsweise im Vergleich zu einer direkten gradlinigen Verbindung zwischen den Messpunkten und dem gemeinsamen Abgriffpunkt, stark reduziert wird. Die Verlegung der Messleitungen als Leiterbahnen kann dabei z. B. auf Grundlage von theoretischen Vorbetrachtungen und/oder mithilfe einer numerischen Simulation erfolgen.

In einer Ausführungsform der Vorrichtung gehen die Messleitungen von den Messkontakten aus und werden an einem gemeinsamen Abgriffspunkt zusammengeführt. Dazu werden die Messleitungen, ausgehend von zumindest einem der Messkontakte, der auf oder nahe der Längs-Mittelachse der Stromschiene angeordnet ist, in zwei Richtungen weg von dem Messkontakt geführt und verlaufen erst nach außen zum Rand des Widerstandsbereichs und dann wieder zurück zum anderen Messkontakt, der ebenfalls auf oder nahe der Längs-Mittelachse der Stromschiene angeordnet ist. Dabei können die Messleitungen bereits vor dem Rand ihren jeweiligen Umkehrpunkt erreichen, den Rand erreichen oder den Rand sogar überschreiten. Der Verlauf der Messleitungen in Richtung Rand und zurück kann zumindest teilweise im Wesentlichen symmetrisch zur Längs-Mittelachse und/oder zur Quer-Mittelachse des Widerstandsbereichs ausgeführt sein.

Kernmerkmal der Verlegung kann dabei z. B. ein Verlauf sein, der zunächst gradlinig quer zur Stromflussrichtung entlang der Verbindungsstege in den Widerstandsbereich verläuft und weiter schräg zur Längs- und Quer-Mittelachse nach außen zum Randbereich des Widerstandsbereichs und schräg zurück nach innen zum anderen Messkontakt führt, wobei dieser Verlauf insgesamt im Wesentlichen symmetrisch zur Längs-Mittelachse und/oder zur Quer-Mittelachse ist.

In einer Ausführungsform der Vorrichtung spannen die Messleitungen einen im Wesentlichen geschlossenen Messleitungsbereich auf, der in einer Dimension zwischen 70 und 100 Prozent der Breite des Widerstandsbereichs und in der dazu senkrechten Dimension zwischen 70 und 100 Prozent des Abstands zwischen den Messkontakten umfasst, wobei die Messleitungen bevorzugt entlang der Verbindungsstege und außerhalb eines Überdeckungsbereiches mit den Aussparungen verlaufen. Die Messleitungen verlaufen damit bevorzugt nicht über den Aussparungen.

In einer Ausführungsform der Vorrichtung können die den Messleitungsbereich aufspannenden Messleitungen aus mehreren parallel zueinander verlaufenden Leiterbahnen bestehen, wobei die einzelnen Leiterbahnen in derselben oder unterschiedlichen Ebenen der Leiterplatte angeordnet sein können.

Die Messleitungen können dabei insbesondere ein Vieleck, z. B. ein Sechseck aufspannen, wobei das Vieleck Symmetrieachsen aufweisen kann, die entlang der Quer-Mittelachse und/oder der Längs-Mittelachse verlaufen. Die Breite des Vielecks kann dabei ca. 70-100% der Breite des Widerstandsbereichs betragen.

Die spezielle Verlegung der Messleitungen ermöglicht eine deutliche Reduzierung der frequenz- und temperaturabhängigen Phasen- und Amplitudenfehler bei der AC-Strommessung mit Stromschienen zur Strommessung im Mikroohm-Bereich. Es wird zudem ein sehr großer Messbereich zwischen Milliampere und Kiloampere realisiert, der einen weitgehend linearen Frequenzgang im Bereich der Netzfrequenz und darüber hinaus im Bereich der regelungstechnisch relevanten Harmonischen der Netzfrequenz aufweisen kann.

Bei der herkömmlichen AC-Strommessung mit Stromschienen zur Strommessung mit großen Abmessungen können aufgrund von Skin-Effekten und Induktion erhebliche Phasenfehler auftreten. Die Phasenfehler, die bei der Strommessung auftreten können, werden durch die oben beschriebene Verlegung der Messleitungen weitgehend vermieden. Der Skin Effekt ruft dabei nicht nur eine frequenz- und positionsabhängige Amplitude, sondern ebenfalls eine frequenz- und positionsabhängige Phase hervor, wobei letztere in der Anwendung häufig deutlich signifikanter auffällt. Induktionsspannungen werden in den Messleitungen zwischen Stromschiene und der Auswerteeinheit hervorgerufen, wenn die Messleitungen mit der Stromschiene eine Fläche aufspannen, die vom zeitvarianten Magnetfeld des zu messenden Stroms durchsetzt wird. Die oben beschriebene Anordnung vermeidet das Aufspannen einer solchen Fläche mit der Stromschiene. Stattdessen wird insbesondere dadurch, dass die Messleitungen einen parallel zur Stromschiene orientierten geschlossenen Messleitungsbereich aufspannen, die Störanfälligkeit gegenüber externen magnetischen Wechselfeldern stark reduziert, weil in den Messleitungen induzierte Spannungen einen Stromfluss innerhalb der praktisch geschlossenen Messleitung hervorrufen, der wiederum durch seinen Ohm'schen Spannungsabfall die induzierten Spannungen kompensiert. Damit ist die Vorrichtung zur Strommessung zur Verwendung mit schnell schaltenden Leistungshalbleitern, z. B. in einem Leistungswandler, gut geeignet, wo eine phasenrichtige Messung der Wechselströme zur Regelung von Oberschwingungen bei hohen Frequenzen vorteilhaft ist.

In einer Ausführungsform der Vorrichtung umfasst die Leiterplatte weitere Leiterbahnen, die als konfigurierbare Kompensationsstruktur zur weiteren Kompensation der oben genannten Effekte ausgeführt und im Widerstandsbereich angeordnet sind. Die Leiterbahnen der Kompensationsstruktur sind elektrisch in Reihe mit einer der Messleitungen verbunden und verlängern insofern die Messleitung. Dabei kann die Kompensationsstruktur insbesondere elektrisch zwischen der Messleitung, die den Messleitungsbereich aufspannt und dem Abgriffpunkt angeordnet sein, oder an einer Unterbrechung einer Messleitung angeschlossen sein. Durch die Reihenschaltung einer Messleitung und der Kompensationsstruktur überlagern sich die in die Leiterbahnen der Kompensationsstruktur induzierten Spannungen mit den in den Messleitungen induzierten Spannungen.

Die Kompensationsstruktur umfasst insbesondere Kompensationsbahnen, die aus Leiterbahnen bestehen, die eine Fläche aufspannen, die senkrecht zur Oberfläche der Stromschiene und parallel zur Stromflussrichtung ausgerichtet ist. Die Kompensationsbahnen umfassen insbesondere Leiterbahnen, die in unterschiedlichen Ebenen oder Lagen der Leiterplatte angeordnet sind und im Wesentlichen parallel zueinander verlaufen sowie Durchkontaktierungen, sogenannte Vias, die Leiterbahnen in unterschiedlichen Ebenen miteinander verbinden.

Eine Kompensationsbahn kann aus zwei Kompensationsarmen bestehen, die gegenläufig orientiert sind. Dabei kann ein Kompensationsarm beispielsweise ausgehend von einem Anschlusspunkt eine erste Leiterbahn in einer ersten Lage der Leiterplatte, eine Durchkontaktierung von der ersten Lage zu einer zweiten Lage, eine zweite Leiterbahn in der zweiten Lage der Leiterplatte, die parallel zur ersten Leiterbahn zurück zum Anschlusspunkt verläuft, und eine weitere Durchkontaktierung von der zweiten zur ersten Lage der Leiterplatte umfassen. Der andere Kompensationsarm einer Kompensationsbahn kann spiegelbildlich zum ersten Kompensationsarm ausgebildet sein, d.h. sich in die entgegengesetzte Richtung des ersten Kompensationsarms und ebenfalls parallel zur Längsachse des Widerstandsbereichs erstrecken. Mittels eines elektrischen Verbinders, beispielsweise einer Drahtbrücke, die den einen oder den anderen der Kompensationsarme mit der Messleitung verbindet, kann dann ausgewählt werden, welcher Kompensationsarm zu der Messleitung hinzugefügt wird, wobei durch den spiegelbildlichen Aufbau der Kompensationsarme eine Kompensation mit unterschiedlichen Vorzeichen realisiert werden kann. Alternativ kann die gesamte Kompensationsbahn mit einer Drahtbrücke überbrückt werden.

In einer Ausführungsform der Vorrichtung können mehrere Kompensationsbahnen räumlich parallel zueinander und elektrisch in Reihe schaltbar angeordnet sein. Dabei weisen die Kompensationsbahnen bevorzugt unterschiedliche Längen auf und spannen somit unterschiedlich große Flächen auf, die zu unterschiedlichen Kompensationsbeiträgen führen. Mittels weiterer elektrischer Verbinder kann dann ausgewählt werden, welche Kompensationsarme welcher Kompensationsbahnen mit der Messleitung verbunden werden, wobei einzelne Kompensationsbahnen durch geeignete Verbinder überbrückt werden können und insofern inaktiv sind. Daraus ergeben sich verschiedene Kombinationsmöglichkeiten mit verschiedenen akkumulierten aufgespannten Flächen, die Kompensationsbeiträge von null (kein Kompensationsarm verbunden) über mehrere Zwischenwerte (ein oder mehrere Kompensationsarme mit gleicher oder gegenläufiger Orientierung verbunden) bis zu einem Maximalwert (alle Kompensationsbahnen mit derselben Ausrichtung verbunden) ergeben.

Es versteht sich, dass die Vorrichtung zur Stromermittlung eine Stromschiene und eine Leiterplatte zur Messwerterfassung aufweist, wobei die Leiterplatte mit den oben beschriebenen Merkmalen auf Stromschienen angeordnet sein kann, die grundsätzlich einen Widerstandsbereich und Spannungsabgriffe aufweist. Insbesondere die Leiterplatte mit der Kompensationsstruktur ist dabei weitgehend unabhängig von der konkreten Form der Stromschiene bzw. der konkreten Ausführung des Widerstandsbereichs in der Stromschiene.

Bei einem Leistungswandler mit stromführenden Leitungen zum Leiten der vom Leistungswandler verarbeiteten Gleich- und/oder Wechselströme weist mindestens eine der stromführenden Leitungen eine Vorrichtung zur Stromermittlung auf, die eine Unterbrechung der zumindest einen stromführenden Leitung überbrückt oder in die zumindest eine stromführende Leitung integriert ist. Der Leistungswandler ist dazu eingerichtet, unter Verwendung einer mittels der Messkontakte erfassten Spannungsdifferenz entlang des Widerstandsbereichs der Stromschiene einen im Betrieb des Leistungswandlers durch die stromführenden Leitungen fließenden Strom zu ermitteln, wobei der Leistungswandler auf eine Nennleistung ausgelegt ist, die größer als 10 kW, bevorzugt größer als 100 kW, besonders bevorzugt größer als 1000 kW ist.

Die durch die anmeldungsgemäße Stromschiene erzielbare hohe Messgenauigkeit ermöglicht es, die vorzuhaltenden Hardwarereserven im Leistungswandler zu reduzieren und/oder eine höhere Nennleistung mit gegebener sonstiger Hardware des Leistungswandler zu erzielen.

In einer Ausführungsform weist der Leistungswandler eine mehrkanalige Vorrichtung zur Stromermittlung auf, wobei die mehrkanalige Vorrichtung eine Mehrkanal-Stromschiene aufweist, wobei die Mehrkanal-Stromschiene auf einer ersten Seite mindestens zwei individuelle Anschlussbereiche zum Anschluss mehrerer stromführender Leitungen und auf einer zweiten Seite eine gemeinsame Sammelschiene als gemeinsamen Anschlussbereich aufweist. Dabei ist den individuellen Anschlussbereichen jeweils ein Widerstandsbereich zugeordnet, der zwischen dem jeweiligen individuellen Anschlussbereich und der Sammelschiene angeordnet ist.

Die Mehrkanal-Stromschiene weist dabei eine Parallelschaltung identischer oder unterschiedlich dimensionierter Widerstandsbereiche auf, in denen grundsätzlich unterschiedliche Ströme fließen, die über den jeweiligen Spannungsabfall zwischen den Messkontakten der jeweiligen Widerstandsbereiche gemessen werden. Die Widerstandsbereiche weisen dabei jeweils eine oben beschriebene optimierte Stromschatten-Geometrien auf. Die Mehrkanal-Stromschiene weist auf einer Seite elektrisch voneinander getrennte erste Anschlussbereiche und jeweilige Widerstandsbereiche auf, die auf der anderen Seite der Mehrkanal-Stromschiene elektrisch und mechanisch miteinander verbunden sind, so dass sich ein gemeinsamer zweiter Anschlussbereich bildet. Verwendung kann eine solche Mehrkanal-Stromschiene beispielsweise in einem DC-Eingangsbereich eines Zentralwechselrichters einer PV-Anlage (Photovoltaik-Anlage) finden, um die PV-Eingangsströme mehrerer Stränge von Photovoltaik-Modulen einerseits individuell zu messen und andererseits als kombinierter Gesamt-PV-Strom einer PV-Sammelschiene zuzuführen.

Mit einer Mehrkanal-Stromschiene sind gegenüber mehreren Einkanal-Stromschienen verringerte Materialkosten realisierbar. Es kann sich eine einfachere Herstellung und Montage, sowie ein reduzierter Logistikaufwand ergeben.

In einer Ausführungsform des Leistungswandlers ist eine Leiterplatte zur Messwerterfassung planparallel zu der Stromschiene angeordnet und liegt insbesondere planparallel auf der Stromschiene auf, wobei die Leiterplatte mehrere Widerstandsbereiche überdeckt und mit den Messkontakten mehrerer Widerstandsbereiche verbunden ist. Durch eine gemeinsame Leiterplatte für Mehrkanal-Stromschienen können diverse Bauteile entfallen, da sie nur einfach statt mehrfach ausgeführt werden müssen, z. B. Netzteile, Mikroprozessoren, Analog-DigitalWandler, Kommunikationstreiber, Verkabelung und ähnliches.

In einer Ausführungsform des Leistungswandlers weist die Leiterplatte eine Auswerteeinheit zur Vorverarbeitung der gemessenen Spannungen und optional Temperaturen der einzelnen Widerstandsbereiche sowie eine galvanische Trennung auf, wobei die Auswerteeinheit über die galvanische Trennung mit einer Steuereinheit des Leistungswandlers verbunden ist. Die Verwendung einer gemeinsamen Leiterplatte für die Messelektronik mit galvanischer Trennung zu einem Kommunikationsmittel bzw. der umgebenden Elektronik, bietet den Vorteil, dass die galvanische Trennung nur einmal für mehrere Messkanäle vorgesehen werden muss. Dies ermöglicht Kostenvorteile. Dies ist insbesondere von Vorteil, wenn eine galvanische Trennung der Messelektronik von der Umgebung notwendig ist, z.B. bei hohen DC-Spannungen an den DC-Eingängen eines PV-Wechselrichters. Hier kann diese Trennung lediglich einmal statt für jede Einkanal-Stromschiene separat aufgebaut werden.

In einer weiteren Ausführungsform weist die Leiterplatte der Mehrkanal-Stromschiene Schlitze auf, die zwischen den Widerstandsbereichen angeordnet sind und sich parallel zur Längs-Mittelachse von einem Rand der Leiterplatte über mindestens die Hälfte der Länge der Leiterplatte erstrecken. Diese Schlitze können zudem paarweise von den gegenüberliegenden Rändern ausgehend nebeneinander angeordnet sein. Sie teilen die Leiterplatte in einzelne, gegeneinander bewegliche Teilbereiche auf, die den jeweiligen Widerstandsbereichen einzeln zugeordnet sind. Dadurch kann die Leiterplatte etwaigen Verformungen der einzelnen Widerstandsbereiche bzw. Anschlussbereiche der Mehrkanal-Stromschiene gegeneinander folgen, so dass sowohl ein Verwinden der Leiterplatte als auch ein partielles Abheben der Leiterplatte von der Oberfläche der Stromschiene im Falle derartiger Verformungen vermieden wird.

Ein Leistungswandler weist stromführende Leitungen zum Leiten der vom Leistungswandler verarbeiteten Gleich- und/oder Wechselströme auf. Mindestens eine der stromführenden Leitungen umfasst eine Vorrichtung zur Stromermittlung gemäß der vorangehenden Beschreibung, wobei die Vorrichtung eine Unterbrechung der stromführenden Leitungen überbrückt oder in die stromführenden Leitungen integriert ist. Der Leistungswandler ist dazu eingerichtet, aus einer mittels der Messkontakte erfassten Spannungsdifferenz entlang des Widerstandsbereichs und einem Widerstandswert des Widerstandsbereichs einen im Betrieb des Leistungswandlers durch die stromführenden Leitungen fließenden Strom zu ermitteln. Dabei kann der zur entsprechenden Berechnung der Stromstärke verwendete Widerstandswert eine Funktion der vom Temperaturfühler erfassten Temperatur ist.

In einer bevorzugten Ausführungsform ist der Leistungswandler auf eine Nennleistung ausgelegt, die größer als 10 kW, bevorzugt größer als 100 kW, besonders bevorzugt größer als 1000 kW ist. In diesen Leistungsklassen ist eine Ermittlung der vom Leistungswandler verarbeiteten Gleich- und/oder Wechselströme aufgrund ihrer entsprechend hohen Amplituden besonders anspruchsvoll und kann mit der beschriebenen Vorrichtung zur Stromermittlung besonders genau durchgeführt werden, wobei die beschriebene Vorrichtung zur Stromermittlung besonders einfach in den Aufbau des Leistungswandler integriert werden kann.

### KURZBESCHREIBUNG DER FIGUREN

Im Folgenden wird der Gegenstand der Anmeldung anhand in den Figuren dargestellter Ausführungsbeispiele weiter erläutert und beschrieben.
- Fign. 1a, 1b, 1c: zeigen schematisch Ausführungsformen von Stromschienen zur Strommessung;
- Fign. 2a, 2b: zeigen schematisch weitere Ausführungsformen von Stromschienen zur Strommessung;
- Fig. 3a: zeigt schematisch eine weitere Ausführungsform einer Stromschiene zur Strommessung;
- Fig. 3b: zeigt schematisch eine Ausführungsform einer Vorrichtung zur Stromermittlung;
- Fig. 4: zeigt schematisch eine Ausführungsform einer mehrkanaligen Vorrichtung zur Stromermittlung; und
- Fig. 5a, 5b, 5c: zeigen schematisch eine Ausführungsform einer Leiterplatte einer Vorrichtung zur Stromermittlung.

In den Figuren sind gleiche oder ähnliche Elemente mit den gleichen Bezugszeichen bezeichnet.

### FIGURENBESCHREIBUNG

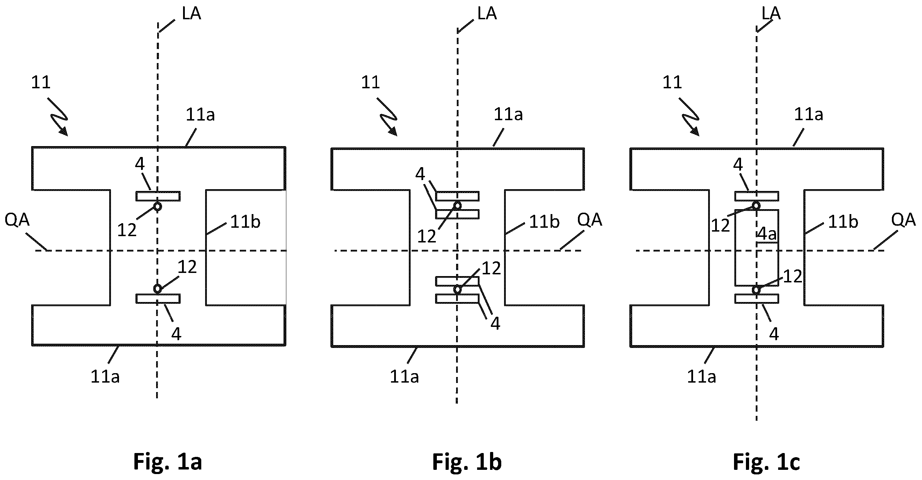

Die Figuren 1a bis 1c zeigen schematisch anmeldungsgemäße Stromschienen 11 zur Strommessung.

Die in Fig. 1a dargestellte Stromschiene 11 weist zwei einander gegenüber liegende Anschlussbereiche 11a und einen zwischen den Anschlussbereichen 11a angeordneten Widerstandsbereich 11b auf, in dem der Querschnitt der Stromschiene 11 im Vergleich zu den Anschlussbereichen 11a kleiner ist. Die Verkleinerung des Querschnittes erfolgt in der dargestellten Stromschiene 11 durch eine Verringerung der Breite der Stromschiene 11 in ihrem Widerstandsbereich 11b; alternativ oder zusätzlich kann die Dicke der Stromschiene 11 im Widerstandsbereich 11b gegenüber den Anschlussbereichen 11a verringert sein. Die Stromschiene ist einstückig ausgeführt und besteht aus Kupfer oder Aluminium. Durch Anschließen eines stromführenden Leiters (nicht dargestellt) an dem einen Anschlussbereich 11a und Fortsetzen des Leiters an dem anderen Anschlussbereich 11a überbrückt die Stromschiene 11 eine Unterbrechung des Leiters. Wird der Leiter von einem elektrischen Strom durchflossen, so wird dann auch die Stromschiene 11 von dem gleichen elektrischen Strom durchflossen, und zwar von dem einen Anschlussbereich 11a über den Widerstandsbereich 11b zu dem anderen Anschlussbereich 11a.

Die dargestellte Stromschiene 11 ist im Wesentlichen symmetrisch zu einer Längs-Mittelachse LA und einer Quer-Mittelachse QA aufgebaut. Im Bereich der Längs-Mittelachse LA sind zwei Messkontakte 12 angeordnet. Die beiden Messkontakte 12 sind zur Quer-Mittelachse QA im Wesentlichen symmetrisch angeordnet. Über die Messkontakte 12 kann eine Spannungs- oder Potentialdifferenz zwischen den Messkontakten 12 erfasst werden. Unter Verwendung des elektrischen Widerstandes des die beiden Messkontakte 12 verbindenden Materials des Widerstandsbereichs 11b kann aus dieser Spannungsdifferenz der Wert des durch die Stromschiene 11 fließenden Stromes ermittelt werden.

Die Messkontakte 12 sind bevorzugt als Einpressstifte ausgeführt, was Vorteile in der Fertigung z. B. bezüglich der Genauigkeit bietet. Die obige Beschreibung trifft in analoger Weise auch auf die in Fig. 1b und 1c dargestellten Stromschienen 11 zu.

Die in Fig. 1a dargestellte Stromschiene 11 weist zu jedem der Messkontakte 12 benachbarte und in Richtung der Längs-Mittelachse LA von den Messkontakten 12 jeweils geringfügig beabstandete Aussparungen 4 auf. Die Aussparungen 4 sind so angeordnet, dass sie einen sogenannten Stromschatten an den Messkontakten 12 bewirken; das bedeutet, dass der Strom im Wesentlichen um die Aussparungen 4 herum fließt und die Messkontakte 12 so durch ihre Anordnung in unmittelbarer Nähe den Aussparungen 4 weitgehend stromlos sind. Hierdurch kann die Messgenauigkeit der zwischen den Messkontakten 12 abfallenden Spannung erhöht werden. Die Aussparungen 4 sind dabei quer, insbesondere senkrecht zu der Längs-Mittelachse LA angeordnet. Sie sind zudem im Wesentlichen symmetrisch zur Längs-Mittelachse LA und im Wesentlichen symmetrisch zueinander bezüglich der Quer-Mittelachse QA angeordnet, so dass die Messkontakte 12 zwischen den Aussparungen 4 angeordnet sind. In einer alternativen, nicht dargestellten Ausführungsform können die Messkontakte 12 auch auf der jeweils anderen Seite der jeweiligen Aussparung 4 angeordnet sein, so dass die Aussparungen 4 zwischen den Messkontakten 12 angeordnet sind.

Die in Fig. 1b dargestellte Stromschiene 11 weist benachbart zu jedem der Messkontakte 12 zwei Aussparungen 4 auf, die in Richtung der Längs-Mittelachse LA gesehen auf den jeweils gegenüberliegenden Seiten der Messpunkte 12 angeordnet sind und sich im Wesentlichen quer, insbesondere senkrecht zur Längs-Mittelachse LA erstrecken. Die Aussparungen 4 sind so angeordnet, dass sie einen sogenannten Stromschatten an den Messkontakten bewirken. Das bedeutet, dass der Strom im Wesentlichen um die paarweise angeordneten Aussparungen 4 herum fließt und die Messkontakte 12 nicht erreicht. Durch die Anordnung der Aussparungen 4 sind die Bereiche der Messkontakte 12 daher weitgehend stromlos. Gegenüber der Stromschiene 11 von Fig. 1a ist durch die paarweise Anordnung der Aussparungen 4 pro Messkontakt 12 dieser Effekt des Stromschattens noch verbessert und die Messgenauigkeit kann weiter verbessert werden. Die Aussparungen 4 können dabei im Wesentlichen symmetrisch zur Längs-Mittelachse LA ausgebildet sein. Die beiden Aussparungen 4 im Bereich eines Messkontaktes 12 sind zudem im Wesentlichen symmetrisch, insbesondere im Wesentlichen punktsymmetrisch zu dem Messkontakt 12 ausgebildet. Zugleich können die beiden Aussparungen 4, die im Bereich eines Messkontaktes 12 angeordnet sind, im Wesentlichen achsensymmetrisch zueinander bezüglich einer Achse sein, die durch den Messkontakt 12 verläuft. Die Aussparungen 4 eines Messkontaktes 12 können zudem bezüglich der Quer-Mittelachse QA im Wesentlichen symmetrisch zu den Aussparungen 4 des anderen Messkontaktes 12 angeordnet sein.

Die in Fig. 1c dargestellte Stromschiene 11 weist benachbart zu jedem der Messkontakte 12 eine Aussparung 4 auf. Die Aussparungen 4 sind dabei quer, insbesondere senkrecht zu der Längs-Mittelachse LA angeordnet. Sie sind zudem im Wesentlichen symmetrisch zur Längs-Mittelachse LA ausgebildet. Die beiden Aussparungen 4 sind zudem im Wesentlichen symmetrisch zueinander bezüglich der Quer-Mittelachse QA angeordnet. Zusätzlich weist die Stromschiene 11 zwischen den beiden Messkontakten 12 eine weitere Aussparung 4a auf. Die weitere Aussparung 4a ist dabei im Bereich der Längs-Mittelachse LA und/oder der Quer-Mittelachse QA angeordnet. Die weitere Aussparung 4a kann beispielsweise im Wesentlichen symmetrisch zur Längs-Mittelachse LA und/oder zur Quer-Mittelachse QA ausgebildet sein und insbesondere an unmittelbar an beide Messkontakte 12 angrenzen.

Die Aussparungen 4 und 4a sind so angeordnet, dass sie einen sogenannten Stromschatten an den Messkontakten 12 bewirken; das bedeutet, dass der Strom im Wesentlichen um die entlang der Längs-Mittelachse LA angeordneten Aussparungen 4 und 4a herum fließt und im Wesentlichen in den stromführenden Bereichen seitlich der Aussparungen 4, 4a geführt wird, so dass insbesondere die Messkontakte 12 durch die Anordnung der Aussparungen 4 und 4a weitgehend stromlos sind. Die weitere Aussparung 4a bewirkt dabei eine noch geringere Stromdichte im Bereich der Messkontakte 12 und eine noch homogenere Stromdichte im stromführenden Bereich des Widerstandsbereiches 11b. Hierdurch kann die Messgenauigkeit weiter erhöht werden.

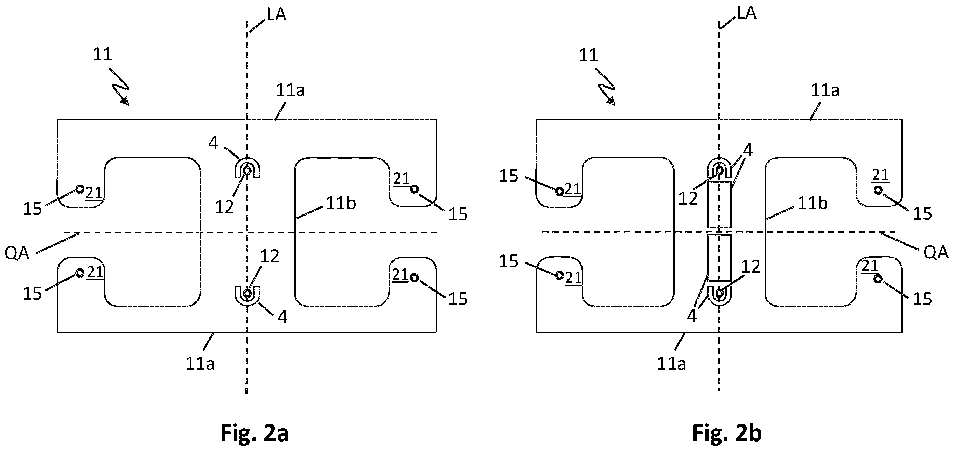

Die Figuren 2a und 2b zeigen schematisch anmeldungsgemäße Stromschienen 11 zur Strommessung.

Die in Fig. 2a dargestellte Stromschiene 11 weist zwei einander gegenüber liegende Anschlussbereiche 11a und den zwischen den Anschlussbereichen 11a angeordneten Widerstandsbereich 11b auf, in dem der Querschnitt der Stromschiene 11 im Vergleich zu den Anschlussbereichen 11a kleiner ist. Die Verkleinerung des Querschnittes erfolgt in der dargestellten Stromschiene 11 durch eine Verringerung der Breite der Stromschiene 11 in ihrem Widerstandsbereich 11b, kann aber auch durch Verringerung der Dicke der Stromschiene 11 im Widerstandsbereich 11b erfolgen. Die Stromschiene ist einstückig ausgeführt und besteht bevorzugt aus einem Material, z. B. Kupfer oder Aluminium. Wenn die Stromschiene 11 eine Unterbrechung eines stromführenden Leiters (nicht dargestellt) überbrückt, wird die Stromschiene 11 von einem elektrischen Strom durchflossen, und zwar von dem einen Anschlussbereich 11a über den Widerstandsbereich 11b zu dem anderen Anschlussbereich 11a.

Die dargestellte Stromschiene 11 ist im Wesentlichen symmetrisch zu einer Längs-Mittelachse LA und einer Quer-Mittelachse QA aufgebaut. Im Bereich der Längs-Mittelachse LA sind zwei Messkontakte 12 angeordnet. Die beiden Messkontakte 12 sind zur Quer-Mittelachse QA im Wesentlichen symmetrisch angeordnet. Über die Messkontakte 12 kann eine Spannungs- oder Potentialdifferenz zwischen den Messkontakten 12 erfasst werden. Unter Verwendung des elektrischen Widerstandes des die beiden Messkontakte 12 verbindenden Materials des Widerstandsbereichs 11b kann aus dieser Spannungsdifferenz der Wert des durch die Stromschiene 11 fließenden Stromes ermittelt werden. Die Messkontakte 12 sind bevorzugt als Einpressstifte ausgeführt, was Vorteile in der Fertigung z. B. bezüglich der Genauigkeit bietet.

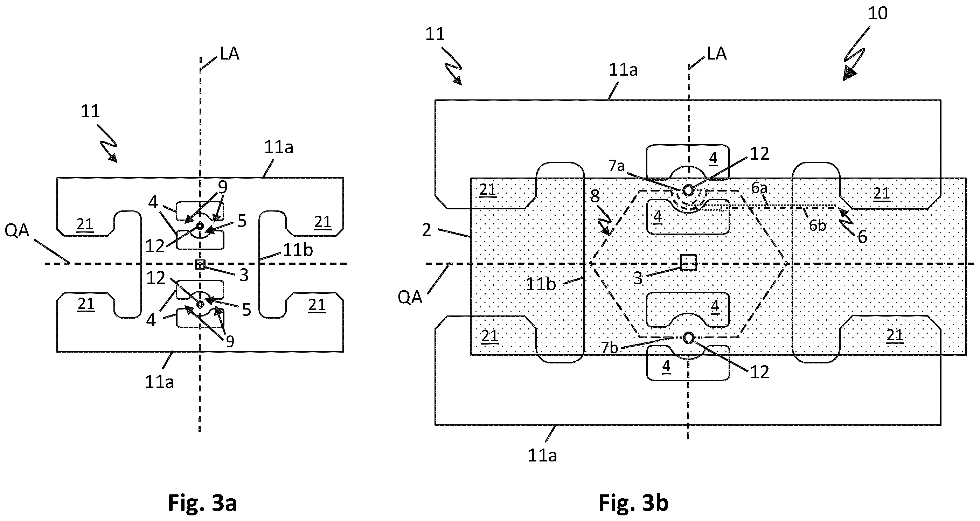

Die Anschlussbereiche 11a der Ausführungsformen gemäß Fig. 2a und Fig. 2b weisen randseitige Verlängerungen in Richtung Stromschienenmitte auf, die als Vorsprünge 21 oder Nasen in die Verjüngung ragen. Die Vorsprünge 21, die sich von gegenüberliegenden Anschlussbereichen 11a aufeinander zu erstrecken, sind durch eine Lücke am Rand der Stromschiene 11 voneinander getrennt, so dass der elektrische Strom ausschließlich durch den Widerstandsbereich 11b fließt. In den Vorsprüngen 21 können bevorzugt Befestigungen, z. B. in Form von Stiften 15, bevorzugt Einpressstiften, vorgesehen sein, die es erlauben, die Stromschiene 11 an anderen Bauteilen zu befestigen und/oder z. B. eine Leiterplatte 2, 20 (vgl. Fign. 3b 4) auf der Stromschiene 11 zu befestigen sowie ggf. elektrisch zu kontaktieren. Die Stifte 15 sind bevorzugt gleichartig wie die Messkontakte 12 ausgebildet. Dies kann die Fertigung weiter vereinfachen. Die obige Beschreibung trifft in analoger Weise auch auf die in Fig. 2b dargestellte Stromschiene 11 zu.

Die in Fig. 2a dargestellte Stromschiene 11 weist um jeden der beiden Messkontakte 12 eine Aussparung 4 auf, die den jeweiligen Messkontakt 12 auf drei Seiten umgibt, wobei die "offenen" Seiten bevorzugt aufeinander zu gerichtet sind. Die Aussparungen 4 sind so angeordnet, dass der Strom im Wesentlichen um die Aussparungen 4 herum fließt und die Messkontakte 12 nicht erreicht, so dass die Bereiche der Messkontakte 12 weitgehend stromlos sind. Die Aussparungen 4 können zumindest teilweise eine Krümmung eines Kreisabschnittes aufweisen oder aus drei oder mehr geraden Abschnitten zusammengesetzt sein. Die beiden Aussparungen 4 können hierbei bevorzugt im Wesentlichen symmetrisch zueinander bezüglich der Quer-Mittelachse QA angeordnet sein. Jede der Aussparungen 4 kann selbst im Wesentlichen symmetrisch zu der Längs-Mittelachse LA ausgebildet sein. Die obige Beschreibung trifft in analoger Weise auch auf die in Fig. 2b dargestellte Stromschiene 11 zu.

Die in Fig. 2b dargestellte Stromschiene weist zusätzlich zwei weitere Aussparungen 4, die so im Bereich der Längs-Mittelachse LA angeordnet sind, dass sie von dieser mittig in Längsrichtung durchschnitten werden und sich vom jeweiligen Messkontakt 12 bis unmittelbar zur Quer-Mittelachse QA erstrecken. Zudem sind die beiden weiteren Aussparungen 4 im Wesentlichen symmetrisch zueinander bezüglich der Quer-Mittelachse QA angeordnet, so dass im Bereich der Quer-Mittelachse QA lediglich ein schmaler Steg verbleibt, auf dem beispielsweise ein weiterer Messpunkt, beispielsweise ein Temperaturfühler angeordnet werden kann. Der Strom fließt im Wesentlichen um die entlang der Längs-Mittelachse LA angeordneten Aussparungen 4 herum und wird im Wesentlichen in den stromführenden Bereichen seitlich der Aussparungen 4 geführt. Hierdurch wird der Stromschatten für die Messkontakte 12 weiter verbessert und die Homogenität der Stromdichte in den seitlich zu den Aussparungen 4 verbleibenden stromführenden Bereichen des Widerstandsbereiches 11b weiter verbessert.

Fig. 3a zeigt schematisch eine Ausführungsform einer anmeldungsgemäßen Stromschiene 11 zur Strommessung. Die Stromschiene 11 weist vier Aussparungen 4 auf, die die Messkontakte 12 jeweils halbbogenförmig umfassen. Zwischen den bezogen auf die Längs-Mittelachse LA mittleren beiden Aussparungen 4 ist ein Temperaturfühler 3 angeordnet.

Die Stromschiene 11 gemäß Fig. 3a weist analog zu den zuvor beschriebenen Stromschienen 11 der Fign. 1a, 1b, 1c, 2a, 2b zwei einander gegenüber liegende Anschlussbereiche 11a und den zwischen den Anschlussbereichen 11a angeordneten Widerstandsbereich 11b auf, in dem der Querschnitt der Stromschiene 11 im Vergleich zu den Anschlussbereichen 11a kleiner ist. Die Verkleinerung des Querschnittes erfolgt in der dargestellten Stromschiene 11 durch eine Verringerung der Breite der Stromschiene 11 in ihrem Widerstandsbereich 11b und kann alternativ oder zusätzlich eine Verringerung der Dicke umfassen. Die Stromschiene ist einstückig ausgeführt und besteht bevorzugt aus einem Material, z. B. Kupfer oder Aluminium. Die Stromschiene 11 wird von einem elektrischen Strom durchflossen, wenn sie eine Unterbrechung eines an die Anschlussbereiche 11a angeschlossenen stromführenden Leiters (nicht dargestellt) überbrückt, wobei der Strom von dem einen Anschlussbereich 11a über den Widerstandsbereich 11b zu dem anderen Anschlussbereich 11a geleitet wird.

Die Stromschiene 11 ist im Wesentlichen symmetrisch zu der Längs-Mittelachse LA, die in Längsrichtung der Stromschiene 11 von einem der Anschlussbereiche 11a zum gegenüberliegenden Anschlussbereich 11a durch den Widerstandsbereich 11b verläuft. Die Messkontakte 12 sind bevorzugt im Bereich der Längs-Mittelachse LA angeordnet. Die dargestellte Stromschiene 11 kann auch im Wesentlichen symmetrisch zu der Quer-Mittelachse QA aufgebaut sein. Die beiden Messkontakte 12 können zur Quer-Mittelachse QA im Wesentlichen symmetrisch angeordnet sein. Über die Messkontakte 12 kann eine Spannungs- oder Potentialdifferenz zwischen den Messkontakten 12 erfasst werden. Unter Verwendung des elektrischen Widerstandes des die beiden Messkontakte 12 verbindenden Materials des Widerstandsbereichs 11b kann aus dieser Spannungsdifferenz der Wert des durch die Stromschiene 11 fließenden Stromes ermittelt werden. Die Messkontakte 12 sind bevorzugt als Einpressstifte ausgeführt, was Vorteile in der Fertigung z. B. bezüglich der Genauigkeit bietet.

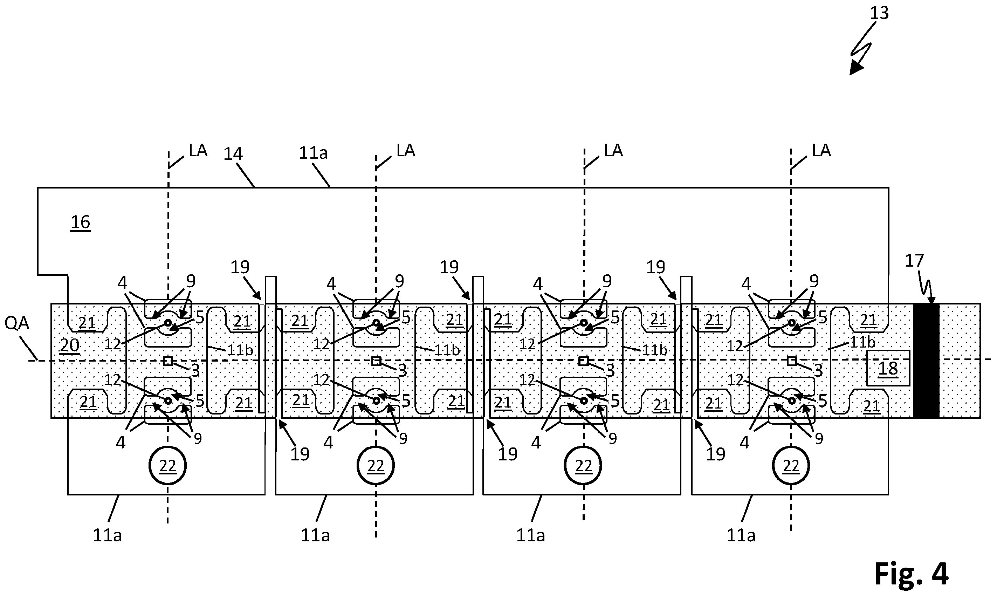

Die Anschlussbereiche 11a weisen randseitige Verlängerungen in Richtung Stromschienenmitte auf, die als Vorsprünge 21 oder Nasen in die Verjüngung ragen. Die Vorsprünge 21, die sich von gegenüberliegenden Anschlussbereichen aufeinander zu erstrecken, sind durch eine Lücke am Rand der Stromschiene 11 voneinander getrennt, so dass der elektrische Strom ausschließlich durch den Widerstandsbereich 11b fließt. In den Vorsprüngen können bevorzugt Befestigungen, z. B. in Form von Stiften 15 (nicht dargestellt, vgl. Fign. 2a, 2b), bevorzugt Einpressstiften, vorgesehen sein, die es erlauben, die Stromschiene 11 an anderen Bauteilen zu befestigen und/oder z. B. eine Leiterplatte 2, 20 (vgl. Fign. 3b, 4) auf der Stromschiene 11 zu befestigen sowie ggf. elektrisch zu kontaktieren. Die Stifte 15 können gleichartig wie die Messkontakte 12 ausgebildet sein.

Die in Fig. 3a dargestellte Stromschiene 11 weist im Bereich jedes der beiden Messkontakte 12 ein Messpunktplateau 5 auf, in dem der Messkontakt 12 angeordnet ist. Auf zwei gegenüberliegenden Seiten jedes Messpunktplateaus 5 befindet sich jeweils eine Aussparung 4, welche das Messpunktplateau 5 bogenförmig teilweise umgibt. Die Aussparungen 4 können zumindest teilweise auf ihrer dem jeweiligen Messpunktplateau 5 zugewandten Seite eine Krümmung eines Kreisabschnittes aufweisen. Die Aussparungen 4 eines Messkontaktes 12 sind hierbei bevorzugt bezüglich der Quer-Mittelachse QA im Wesentlichen symmetrisch zu den Aussparungen 4 des anderen Messkontaktes angeordnet, so dass auch die Messpunktplateaus 5 symmetrisch zueinander bezüglich der Quer-Mittelachse QA sind.

Jede der Aussparungen 4 erstreckt sich quer, insbesondere senkrecht zur Längs-Mittelachse LA und kann selbst im Wesentlichen symmetrisch zu der Längs-Mittelachse LA ausgebildet sein. Die Aussparungen 4 können in Richtung der Längs-Mittelachse jeweils eine Breite zwischen zwei und zehn Millimeter aufweisen. Die zwei Aussparungen 4, die im Bereich eines Messkontakt 12 angeordnet sind, können im Wesentlichen symmetrisch zum Messkontakt 12, insbesondere im Wesentlichen punktsymmetrisch zum Messkontakt 12 und/oder im Wesentlichen achsensymmetrisch zu einer durch den Messkontakt 12 verlaufenden Achse ausgebildet sein.

Durch die Aussparungen 4 sind die Messpunktplateaus im Wesentlichen stromfrei, da der Strom um die Aussparungen 4 herum fließt und die Messpunktplateaus 5 nicht erreicht. Die Messpunktplateaus 5 sind nur noch über jeweils zwei Verbindungsstege 9 mit dem stromführenden Bereich des Widerstandsbereichs 11b verbunden. Die Verbindungsstege 9 können quer, insbesondere senkrecht zur Längs-Mittelachse LA verlaufen, so dass der im Wesentlichen parallel zur Längs-Mittelachse LA fließende Strom nicht oder nur sehr wenig in die Verbindungsstege 5 eindringt. Über die Verbindungsstege 5 liegt das jeweilige Messpunktplateau 5 auf einem Potential, das dem Potential an den Schnittstellen der Verbindungsstege 5 mit dem stromführenden Bereich des Widerstandsbereichs 11b entspricht, so dass die Spannungsdifferenz zwischen den Messkontakten 12 im Wesentlichen der Spannungsdifferenz zwischen diesen Schnittstellen entspricht.

Die Verbindungsstege 9 können eine Breite, d. h. eine Ausdehnung in Richtung der Längs-Mittelachse LA, zwischen zwei und fünf Millimetern aufweisen. Die Messpunktplateaus 5 können eine Längsausdehnung, d. h. eine Ausdehnung in Richtung der Längs-Mittelachse LA und/oder Quer-Mittelachse QA, zwischen fünf und zwölf Millimetern aufweisen. Die in Fig. 3a dargestellte Stromschiene 11 weist somit Maße und Mindestgrößen von Strukturen (Aussparungen 4 und verbleibende Stege) von z. b. 3 mm auf, so dass sie in einem kostengünstigen Stanzprozess hergestellt werden kann.

Der Temperaturfühler 3 kann mittig des Widerstandsbereichs 11b und mittig zwischen den Messkontakten 12 platziert werden, so dass die Temperatur in genau jenem Bereich in der Mitte des Spannungsabfalls zwischen den Messkontakten 12 gemessen wird. Dadurch können temperaturbedingte Änderungen des Widerstandes des Materials der Stromschiene 11 im Widerstandsbereich 11b der Stromschiene 11 im Rahmen einer Ermittlung des Stromschiene 11 durchfließenden Stroms optimal kompensiert werden. Sowohl an den Messkontakten 12 als auch am Temperaturfühler 3 liegen jeweils die Mittelwerte der entsprechenden Spannungen bzw. Temperaturen aus den jeweils angrenzenden gegenüberliegenden stromführenden Bereichen der Stromschiene 11 vor. Damit führt eine ungleichmäßige Strom- oder Temperaturverteilung in den gegenüberliegenden stromführenden Bereichen der Stromschiene 11 nicht zur Verfälschung der Messungen.

In einer nicht dargestellten Ausführungsform können zwei Temperaturfühler in den stromführenden Bereichen der Stromschiene platziert werden. Dies ist insbesondere sinnvoll, wenn die einander zugewandten Aussparungen 4 ineinander übergehen und eine gemeinsame Aussparung 4a bilden, so dass kein Material entlang der Längs-Mittelachse LA zwischen den Messpunktplateaus verbleibt (vergl. Fig. 1c). Bevorzugt würden die zwei Temperaturfühler auf der Quer-Mittelachse und im Wesentlichen symmetrisch um die Längs-Mittelachse angeordnet sein, also insbesondere in den stromführenden Bereichen seitlich der Aussparungen 4. Dies kann das Reaktionsverhalten der Strommessung bei sprunghaften Wechseln der zu messenden Stromstärke verbessern, weil dann direkt dort gemessen wird, wo die Wärme entsteht, nämlich in den effektiv stromführenden Bereichen des Widerstandsbereichs.

In Fig. 3b ist eine Vorrichtung zur Stromermittlung 10 mit der Stromschiene 11 von Fig. 3a und einer Leiterplatte 2 dargestellt. Die Leiterplatte 2 kann auf der Stromschiene aufliegen und z. B. mit Stiften 15 (vgl. Fign. 2a, 2b) auf der Stromschiene 11 befestigt sein, insbesondere auf den Vorsprüngen 21, wobei die Stifte 15 gleichartig mit den Messkontakten 12 ausgebildet sein können.

Die Leiterplatte 2 kann weitgehend distanzfrei auf der Oberfläche des Widerstandsbereichs 11b aufliegen. Leiterbahnen in der Leiterplatte 2, die die Messkontakte 12 als Messleitungen 6a, 6b, 7a, 7b mit einer Auswerteeinheit 18 (nicht dargestellt) zur Ermittlung der zwischen den Messkontakten 12 abfallenden Spannung verbinden, liegen dadurch ebenfalls eng an der Oberfläche des Widerstandsbereichs 11b an und Leiterschleifen bei der Spannungsmessung werden weitgehend vermieden. Die Geometrie der Anordnung der Messleitungen 7a, 7b auf der Leiterplatte 2 kann weitgehend unabhängig von Stromschienen- und Stromschatten-Geometrie erfolgen, jedoch ist es vorteilhaft, wenn die Messleitungen 7a, 7b über dem verbleibenden Material des Widerstandsbereichs 11b und nicht über Aussparungen 4 verlaufen. Eine Leiterplatte 2, wie in Fig. 3b dargestellt, kann deshalb auch in Verbindung mit anderen Stromschienen 11, z. B. aus Fig. 1a, 1b, 1c, 2a, 2b Verwendung finden. Eine Anpassung der Anordnung der Messleitungen 7a, 7b kann dabei entsprechend vorgenommen werden.

Die Messleitungen 7a, 7b sind so als Leiterbahnen innerhalb der Leiterplatte 2 verlegt, dass frequenzabhängige Phasenmessfehler reduziert werden. Die Messleitungen 7a, 7b zur Verbindung der Messkontakte 12 mit einer Auswerteeinheit 18 (nicht dargestellt) können dabei als Leiterbahnen innerhalb einer Leiterplatte 2 derart entlang einer Bahn an der Oberfläche der Stromschiene 11 verlegt werden, dass der Phasenfehler im Vergleich zu einer weniger optimierten Verlegung der Messleitungen 7a, 7b stark reduziert wird. Im in Fig. 3b dargestellten Beispiel der Vorrichtung 10 gehen die Messleitungen 7a, 7b von den Messkontakten 12 aus, spannen einen Messleitungsbereich 8 in Form eines Vielecks auf und werden über Messabgriffleitungen 6a, 6b an einem gemeinsamen Abgriffpunkt 6 zusammengeführt. An den Abgriffpunkt 6 kann eine geeignete Auswerteeinheit 18 (nicht dargestellt) die Potentiale der beiden Messkontakte 12 erfassen. Die Messleitungen 7a, 7b können dabei teilweise im Wesentlichen symmetrisch zur Längs-Mittelachse und/oder zur Quer-Mittelachse des Widerstandsbereichs verlaufen.

Der Messleitungsbereich 8 kann dabei insbesondere ein Vieleck, z. B. ein Sechseck, aufspannen, wobei das Vieleck Symmetrieachsen aufweisen kann, die entlang der Quer-Mittelachse und/oder der Längs-Mittelachse verlaufen. Die Breite des Vielecks kann dabei ca. 70-100% oder 70-85% der Breite des Widerstandsbereichs betragen. Zudem können die Seiten des Vielecks durch mehrere parallel verlaufende Leiterbahnen gebildet werden

In einer Ausführungsform der Vorrichtung 10 ist es möglich, den Temperaturfühler 3 und die Auswerteeinheit 18 (nicht dargestellt) auf der der Stromschiene 11 gegenüberliegenden Seite der Leiterplatte 2 anzuordnen.

Fig. 4 zeigt eine mehrkanalige Vorrichtung zur Stromermittlung 13 mit einer Mehrkanal-Stromschiene 14, auf der eine Leiterplatte 20 angeordnet ist.

Die Mehrkanal-Stromschiene 14 weist auf einer ersten Seite vier individuelle Anschlussbereiche 11a mit Anschlusselementen 22 zum Anschluss mehrerer stromführender Leitungen auf. Auf einer den Anschlusselementen 22 gegenüberliegenden zweiten Seite weist die Mehrkanal-Stromschiene 14 eine gemeinsame Sammelschiene 16 als gemeinsamen Anschlussbereich 11a für eine gemeinsame stromführende Leitung auf. Den individuellen Anschlussbereichen 11a ist jeweils ein Widerstandsbereich 11b zugeordnet, der zwischen dem jeweiligen individuellen Anschlussbereich 11a und der Sammelschiene 16 angeordnet ist. Die Mehrkanal-Stromschiene 14 weist dabei eine Parallelschaltung identischer oder unterschiedlich dimensionierter Widerstandsbereiche 11b auf, in denen grundsätzlich unterschiedliche Ströme fließen, die über den jeweiligen Spannungsabfall zwischen den Messkontakten 12 der jeweiligen Widerstandsbereiche 11b gemessen werden. Die Widerstandsbereiche 11b weisen dabei eine oben beschriebene optimierte Stromschatten-Geometrien auf. Die Mehrkanal-Stromschiene 14 weist auf einer Seite voneinander getrennte erste Anschlussbereiche 11a und jeweilige Widerstandsbereiche 11b auf, die auf der anderen Seite der Mehrkanal-Stromschiene elektrisch und mechanisch miteinander verbunden sind, so dass sich ein gemeinsamer zweiter Anschlussbereich in Form einer Sammelschiene 16 bildet.

Die Geometrie der jeweiligen Widerstandsbereiche 11b entspricht im dargestellten Beispiel der Geometrie der Stromschiene 11 aus Fig. 3a. Der Widerstandsbereich 11b weist entsprechend der Stromschiene 11 von Fig. 3a einen oder mehrere Temperaturfühler 3 auf, und die Messkontakte 12 befinden sich entsprechend der Stromschiene 11 von Fig. 3a auf Messpunktplateaus 5, die mit Verbindungsstegen 9 mit stromführenden Bereichen des Widerstandsbereiches 11b verbunden sind. Auch die Anordnung und Ausformung der Aussparungen 4 kann der von Fig. 3a entsprechen, wobei in Fig. 4 die Quer-Mittelachse QA und die Längs-Mittelachsen LA entsprechend eingezeichnet sind. Es ist ebenso möglich, eine Mehrkanal-Stromschiene aus individuellen Stromschienen-Geometrien aufzubauen, wie sie z. B. den Stromschienen 11 aus den Fign. 1a, 1b, 1c, 2a, 2b entsprechen.

Die Leiterplatte 20 zur Messwerterfassung liegt planparallel auf der Stromschiene 14 auf, wobei die Leiterplatte 20 mehrere Widerstandsbereiche 11b überdeckt und mit den Messkontakten 12 mehrerer Widerstandsbereiche 11b verbunden ist. In der Leiterplatte 20 sind Messleitungen angeordnet, die in analoger Weise wie zu Fig. 3a dargestellt ausgeführt sein können und insbesondere als Leiterbahnen in der Leiterplatte 20 geführt werden. Über die Messleitungen werden die Messwerte von den Messkontakten 12 an die Auswerteeinheit 18 übermittelt. Durch eine gemeinsame Leiterplatte 20 für Mehrkanal-Stromschienen 14 können diverse Bauteile entfallen, da sie nur einfach statt mehrfach ausgeführt werden müssen, z. B. galvanische Trennung 17, Netzteile, Auswerteeinheit 18, Analog-DigitalWandler, Kommunikationstreiber, Verkabelung und ähnliches.

Eine möglichst flächenbündige Anordnung der Leiterplatte 20 auf der Mehrkanal-Stromschiene 14 ist aus den bereits genannten Gründen erstrebenswert. Im Betrieb einer Stromschiene 14 in einem Leistungswandler können insbesondere durch thermische und elektromechanische Effekte, die bei hohen Betriebsströmen auf die Mehrkanal-Stromschiene 14 wirken, Verformungen der Mehrkanal-Stromschiene 14, insbesondere einzelner Widerstandsbereiche 11b gegeneinander, und/oder der Leiterplatte 20 entstehen. Solche Verformungen können zu einem zumindest partiellen Abheben der Leiterplatte 20 von der Mehrkanal-Stromschiene 14 führen. Dieses Abheben der Leiterplatte 20 von der Oberfläche der Mehrkanal-Stromschiene 14 kann durch Schlitze 19 in der Leiterplatte 20 ausgeglichen werden, die jeweils zwischen den Widerstandsbereichen 11b angeordnet sind und sich parallel zur Längs-Mittelache LA von einem Rand der Leiterplatte 20 über mindestens die Hälfte der Länge der Leiterplatte 20 erstrecken. Die Schlitze 19 ermöglichen ein leichtes "Verdrehen" der den einzelnen Widerstandsbereichen 11b zugeordneten Abschnitte der Leiterplatte 20 gegeneinander. Dadurch kann die Leiterplatte 20 etwaigen Verformungen der einzelnen Widerstandsbereiche 11b bzw. Anschlussbereiche 11a gegeneinander abschnittsweise folgen und somit mechanische Spannungen auf der Vorrichtung 13 vermindern.

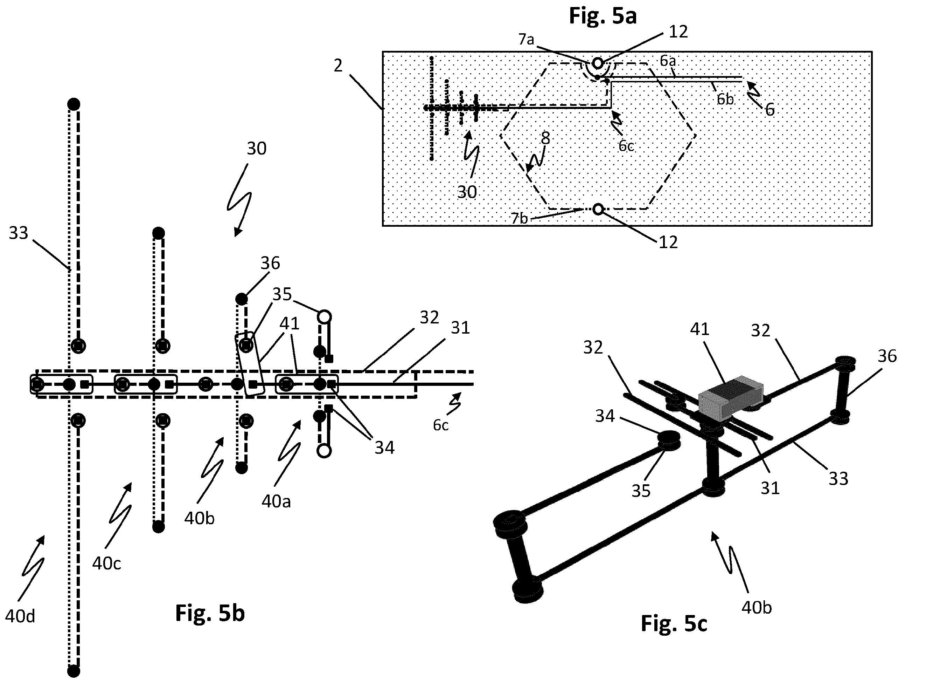

Die Figuren 5a-5c zeigen eine Ausführungsform einer Leiterplatte einer Vorrichtung zur Stromermittlung in verschiedenen Ansichten. Fig. 5a zeigt eine Leiterplatte 2, die analog zu Fig. 3b auf einer Stromschiene 11 (hier nicht dargestellt) angeordnet sein kann und mittels der Messkontakte 12 die über den Widerstandsbereich 11b der Stromschiene 11 abfallende Spannung erfasst. Dazu weist die Leiterplatte 2 die Messleitungen 7a, 7b auf, die einen Messleitungsbereich 8 aufspannen sowie die Messkontakte 12 mit den Messabgriffleitungen 6a, 6b und dem Abgriffpunkt 6 verbinden. Zusätzlich weist die Leiterplatte 2 eine Kompensationsstruktur 30 auf, die bevorzugt im Widerstandsbereich der Stromschiene 11 angeordnet und über eine weitere Messabgriffleitung 6c elektrisch in Reihe mit der Messleitung 7b verbunden ist.

Eine Kompensationsstruktur 30 mit einer konkreten Konfiguration ist in Fig. 5b vergrößert abgebildet. Dabei stellen die durchgezogenen Linien Leiterbahnen 31 in einer ersten Lage (Lage #1) der Leiterplatte 2 dar, während die gestrichelten Linien Leiterbahnen 32 und die gepunkteten Linien Leiterbahnen 33 in einer zweiten Lage (Lage #2) bzw. einer dritten Lage (Lage #3) der Leiterplatte 2 repräsentieren. Die Lagen #1, #2, und #3 befinden sich in verschiedenen Ebenen der Leiterplatte 2. Die Kompensationsstruktur 30 umfasst mehrere Kompensationsbahnen 40a, 40b, 40c, 40d, die parallel zueinander und bei Anordnung der Leiterplatte 2 auf einer Stromschiene 11 parallel zur Längsachse der Stromschiene 11 angeordnet sind. Die Kompensationsbahnen 40a, 40b, 40c, 40d weisen jeweils zwei gegenläufig orientierte Kompensationsarme auf, die weiter unten in Verbindung mit Fig. 5c näher erläutert werden.

In der beispielhaften konkreten Konfiguration gemäß Fig. 5b ist nur ein Kompensationsarm der zweiten Kompensationsbahn 40b mit der Messleitung 7b verbunden. Ausgehend von der Messabgriffleitung 6c ergibt sich der im Folgenden beschriebene Stromkreis als Verlängerung der Messleitung 7b. Der Leiterbahn 31 in Lage #1 entlang der horizontalen Mittelachse der Kompensationsstruktur 33 folgend, endet die Leiterbahn 31 zunächst an einem Lötpunkt 34, der der Kompensationsbahn 40a zugeordnet ist. Mittels eines elektrischen Verbinders, hier beispielhaft mittels einer Brücke 41, wird dieser Lötpunkt 34 mit einem weiteren Lötpunkt 34 auf der Mittelachse verbunden, so dass die Kompensationsbahn 40a überbrückt ist, d.h. die Kompensationsbahn 40a ist in diesem Beispiel ungenutzt. Im weiteren Verlauf erreicht die Leiterbahn 31 den nächsten Lötpunkt 34, der der Kompensationsbahn 40b zugeordnet ist. Mittels einer weiteren Brücke 41 wird die Leiterbahn 31 mit einem Lötpunkt 34 verbunden, der dem oberen Kompensationsarm der Kompensationsbahn 40b zugeordnet ist und mit einem Via 35 zwischen Lage #1 und Lage #2 zusammenfällt, so dass die Leiterbahn 31 über die Brücke 41 und das Via 35 mit einer Leiterbahn 32 in Lage #2 verbunden ist. Am äußeren Endpunkt des Kompensationsarms ist die Leiterbahn 32 über ein Via 36 zwischen Labe #2 und Lage #3 mit einer Leiterbahn 33 in Lage #3 der Leiterplatte 2 verbunden, und die Leiterbahn 33 führt zurück zu einem Via 36 an der Mittelachse der Kompensationsstruktur 30. Von dort führt eine Leiterbahn 32 in Lage #2, ein Via 35 und eine Leiterbahn 31 zu einem Lötpunkt 34, der der Kompensationsbahn 40c zugeordnet. Die Kompensationsbahnen 40c und 40d werden in diesem Beispiel ebenfalls nicht genutzt und mittels je einer Brücke 41 umgangen. Schließlich führt eine Leiterbahn 32 beidseitig der Mittelachse der Kompensationsstruktur zurück zur Messabgriffleitung 6c und wird dort zusammengeführt.

Es versteht sich, dass die Anzahl von vier Kompensationsbahnen 40a-40d ebenso wie deren jeweilige Länge und Reihenfolge lediglich beispielhaft zu verstehen ist. Es sind Kompensationsstrukturen 30 mit einer beliebigen Anzahl weiterer Kompensationsbahnen denkbar, wobei jede Kompensationsbahn entweder genutzt werden kann, indem einer der jeweiligen Kompensationsarme an die Messleitung 7b angebunden wird, oder aber überbrückt und damit nicht genutzt werden kann.

Fig. 5c zeigt eine Detailansicht der Kompensationsbahn 40b aus Fig. 5b. Die Leiterbahn 31, die gemäß Fig. 5b letztlich mit der Messabgriffleitung 6c verbunden ist, ist mittels der Brücke 41 mit einer Leiterbahn 32 verbunden, die zu einem der beiden Kompensationsarme der Kompensationsbahn 40b gehört. Dieser Kompensationsarm wird durch den entsprechenden Abschnitt der Leiterbahn 32 in Lage #2, ein Via 36 zwischen Lage #2 und Lage #3, einen Abschnitt der Leiterbahn 33 in Lage #3 und ein weiteres Via 36 gebildet, so dass der Kompensationsarm eine nahezu geschlossene Leiterschleife bildet, die senkrecht zur Oberfläche der Leiterplatte (und damit senkrecht zur Stromschiene 11) sowie parallel zur Längs-Mittelachse LA der Stromschiene ausgerichtet ist. Der andere Kompensationsarm der Kompensationsbahn 40b ist mangels entsprechend platzierter Brücke nicht mit der Messleitung 7b verbunden und insofern ungenutzt.

Alternativ zum oberen Kompensationsarm der Kompensationsbahn 40b kann bei Bedarf der untere Kompensationsarm der Kompensationsbahn 40b mittels einer entsprechend platzierten Brücke 41 mit der Messleitung 7b verbunden werden, oder die Kompensationsbahn 40b wird nicht genutzt und mittels einer entsprechend platzierten Brücke 41 überbrückt. Zusätzlich können einzelne oder mehrere der Kompensationsarme der anderen Kompensationsbahnen 40a, 40c und/oder 40d mittels geeignet platzierter Brücken 41 mit der Messleitung verbunden werden. Dabei ist zu beachten, dass die jeweils gegenläufig ausgerichteten Kompensationsarme einer Kompensationsbahn einen Kompensationseffekt gleicher Größenordnung, jedoch mit unterschiedlichem Vorzeichen bewirken.

Die Kompensationsbahnen 40a-40d spannen bevorzugt Flächen mit unterschiedlichem Querschnittsflächen auf. Dazu können sowohl die Länge der Arme, d.h. die Breite der jeweiligen aufgespannten Fläche, als auch der Abstand der gegenüberliegenden Leiterbahnen, d.h. die Höhe der aufgespannten Fläche geeignet gewählt werden. Darüber hinaus kann ein Kompensationsarm aus mehreren Schleifen bestehen, wodurch die aufgespannte Fläche entsprechend vervielfältigt wird.

In konkreten Ausführungsformen sind die Kompensationsarme mindestens einen Millimeter und maximal 20 Millimeter lang. Der Abstand zwischen den Leiterbahnen eines Kompensationsarm in den verschiedenen Ebenen der Leiterplatte ist durch die Dicke der Leiterplatte und die Anzahl der Ebenen in der Leiterplatte begrenzt und beträgt zwischen etwa 0,2 Millimeter und etwa 10 mm.

Durch die verschieden großen aufgespannten Flächen der Kompensationsbahnen 40a-40d ergeben sich damit eine Anzahl an Kombinationsmöglichkeiten mit jeweils unterschiedlichem Kompensationseffekten. In dem konkreten Beispiel gemäß Fig. 5b können insgesamt 15 verschiedene Kombinationen durch Verwendung der oberen Kompensationsarme, weitere 15 verschiedene Kombinationen der unteren Kompensationsarme und einige Mischformen unter Nutzung von unteren und oberen Kompensationsarmen erzeugt werden, die insbesondere dann unterschiedliche Kompensationseffekte mit unterschiedlichen Amplituden und ggf. Vorzeichen aufweisen, wenn die aufgespannten Flächen mit Zweierpotenzen anwachsen.

In einer konkreten Anwendung der Leiterplatte 2 gemäß Fig. 5a in einer Vorrichtung 10, z.B. gemäß Fig. 3b, kann mittels einer Kalibrierungsmessung ermittelt werden, welche Effekte das Messergebnis in einer konkreten Ausführungsform mit welcher Größenordnung beeinflussen. Dazu kann beispielsweise die Stromschiene 11 mit einem definierten Strom beaufschlagt und das am Abgriffpunkt 6 erfasste Spannungssignal ausgewertet werden, während alle Kompensationsbahnen 40a-40b überbrückt sind und die Kompensationsstruktur insofern inaktiv ist. Je nach festgestellter Verfälschung der Messwerte, die beispielsweise eine Nichtlinearität des Spannungssignals im Verhältnis zum Strom in der Stromschiene 11 umfassen kann, wird entschieden, ob und ggf. welche Kompensationsarme der Kompensationsbahnen 40a-40d mit der Messleitung 7b verbunden werden sollte, um die unerwünschten Einflüsse des zu messenden Stroms auf die Messleitungen 7a, 76 und damit auf das Messergebnis zu minimieren. Im Ergebnis wird eine Konfiguration der Kompensationsstruktur festgelegt, die eine optimale Kompensation der unerwünschten Einflüsse dauerhaft gewährleistet und insbesondere frequenzabhängige Phasen- und Amplitudenmessfehler minimiert. Diese Konfiguration kann im Falle einer Mehrkanal-Stromschiene 14 gemäß Fig. 4 individuell für die Messungen an den einzelnen Kanälen festgelegt werden, um die Messungen an den einzelnen Kanälen individuell zu optimieren.

### BEZUGSZEICHENLISTE

- 2: Leiterplatte
- 3: Temperaturfühler
- 4, 4a: Aussparung
- 5: Messpunktplateau
- 6a, 6b, 6c: Messabgriffleitung
- 7a, 7b: Messleitung
- 8: Messleitungsbereich
- 9: Verbindungssteg
- 10: Vorrichtung zur Stromermittlung
- 11: Stromschiene
- 11a: Anschlussbereich
- 11b: Widerstandsbereich
- 12: Messkontakt
- 13: mehrkanalige Vorrichtung zur Stromermittlung
- 14: Mehrkanal-Stromschiene
- 15: Stift
- 16: Sammelschiene
- 17: Galvanische Trennung
- 18: Auswerteeinheit
- 19: Schlitz
- 20: Leiterplatte
- 21: Vorsprung
- 22: Anschlusselement
- 30: Kompensationsstruktur
- 31: Leiterbahn in Lage #1
- 32: Leiterbahn in Lage #2
- 33: Leiterbahn in Lage #3
- 34: Lötpunkt
- 35: Via zwischen Lage #1 und Lage #2
- 36: Via zwischen Lage #2 und Lage #3
- 40a-d: Kompensationsbahn
- 41: Brücke
- LA: Längs-Mittelachse
- QA: Quer-Mittelachse

## Patentansprüche

1. Vorrichtung zur Stromermittlung (10) mit einer Stromschiene (11, 14), wobei die Stromschiene (11,14) Anschlussbereiche (11a) und mindestens einen zwischen den Anschlussbereichen (11a) angeordneten Widerstandsbereich (11b) zur Strommessung eines Gleich- und/oder Wechselstroms, insbesondere mit Stromstärken größer als 100 Ampere aufweist, wobei der Widerstandsbereich (11b) im Wesentlichen durch eine Verjüngung des Querschnitts gegenüber dem Querschnitt der Anschlussbereiche (11a) der Stromschiene (11, 14) gebildet wird, wobei zwei Messkontakte (12) im Widerstandsbereich (11b) angeordnet sind, wobei die Stromschiene (11, 14) im Widerstandsbereich (11b) zumindest zwei Aussparungen (4, 4a) aufweist, welche im Bereich der Messkontakte (12) angeordnet und in Längsrichtung von den Messkontakten (12) beabstandet sind, so dass die Bereiche der Messkontakte (12) während des Betriebs der Stromschiene (11, 14) im Wesentlichen stromlos sind, wobei die Stromschiene (11, 14) einstückig ausgebildet ist und aus Kupfer oder Aluminium besteht, und mit einer planparallel zu der Stromschiene (11, 14) angeordneten Leiterplatte (2, 20) zur Messwerterfassung, wobei die Messwerterfassung eine Erfassung einer Spannungsdifferenz zwischen den zwei Messkontakten (12) und eine Temperaturerfassung des Widerstandsbereichs (11b) über mindestens einen Temperaturfühler (3) umfasst.

2. Vorrichtung nach Anspruch 1, wobei die Verjüngung insbesondere durch eine Reduzierung der Breite des Widerstandsbereiches (11b) auf einen Wert zwischen 10 und 60 Prozent der Breite der Anschlussbereiche (11a) der Stromschiene (11, 14) gebildet wird.

3. Vorrichtung nach Anspruch 1 oder 2, wobei die Messkontakte (12) als Einpressstifte ausgeführt sind, die in Einpressbohrungen in der Stromschiene (11, 14) eingepresst sind.

4. Vorrichtung nach einem der vorangehenden Ansprüche, wobei die Messwerterfassung über Messleitungen (7a, 7b) erfolgt, welche die Messkontakte (12) mit einem gemeinsamen Abgriffpunkt (6) verbinden und so als Leiterbahnen innerhalb der Leiterplatte (2, 20) verlegt sind, dass frequenzabhängige Phasen- und Amplitudenmessfehler reduziert werden.

5. Vorrichtung nach Anspruch 4, wobei die Messleitungen (7a, 7b) in einer Ebene der Leiterplatte (2, 20) verlaufen, die als äußerste Innenlage der Leitplatte (2, 20) auf der dem Widerstandsbereich (11b) zugewandten Seite der Leiterplatte (2, 20) angeordnet ist.

6. Vorrichtung nach Anspruch 4 oder 5, wobei die Messleitungen (7a, 7b) von den Messkontakten (12) ausgehen und so an den gemeinsamen Abgriffspunkt (6) zusammengeführt werden, dass die Messleitungen (7a, 7b) von zumindest einem der Messkontakte (12) eines Widerstandsbereichs (11b) ausgehend in zwei Richtungen weg von dem Messkontakt (12) zum Rand des Widerstandsbereichs (11b) geführt werden und insbesondere zumindest teilweise im Wesentlichen symmetrisch zu einer Längs-Mittelachse (LA) und/oder zu einer Quer-Mittelachse (QA) des Widerstandsbereichs (11b) verlaufen.

7. Vorrichtung nach einem der Ansprüche 4 bis 6, wobei die Messleitungen (7a, 7b) einen im Wesentlichen geschlossenen Messleitungsbereich (8) aufspannen, der in einer Dimension zwischen 70 und 100 Prozent der Breite des Widerstandsbereichs (11b) und in der dazu senkrechten Dimension zwischen 70 und 100 Prozent des Abstands zwischen den Messkontakten (12) umfasst.

8. Vorrichtung nach einem der Ansprüche 4 bis 7, wobei die Leiterplatte (2, 20) eine Kompensationsstruktur (30) aufweist, wobei die Kompensationsstruktur (30) mehrere Kompensationsbahnen (40a, 40b, 40c, 40d) umfasst, die räumlich parallel zueinander angeordnet sind und elektrisch in Reihe mit einer der Messleitungen (7a, 7b) verbindbar sind, wobei die Kompensationsbahnen (40a, 40b, 40c, 40d) aus Leiterbahnen (31, 32, 33) in unterschiedlichen Ebenen der Leiterplatte (2, 20) bestehen und jeweils eine Fläche aufspannen, die senkrecht zur Stromschiene (11, 14) und parallel zur Längs-Mittelachse (LA) orientiert ist.

9. Vorrichtung nach Anspruch 8, wobei die Kompensationsbahnen (40a, 40b, 40c, 40d) jeweils zwei gegenläufig orientierte Kompensationsarme aufweisen, wobei von jeder Kompensationsbahn (40a, 40b, 40c, 40d) ein Kompensationsarm mit der Messleitung (7a, 7b) verbindbar ist.

10. Vorrichtung nach Anspruch 8 oder 9, wobei die Kompensationsbahnen (40a, 40b, 40c, 40d) jeweils mittels eines bestückbaren elektrischen Verbinders (41) überbrückt oder mit der Messleitung (7a, 7b) verbunden sind.

11. Leistungswandler mit stromführenden Leitungen zum Leiten der vom Leistungswandler verarbeiteten Gleich- und/oder Wechselströme, wobei mindestens eine der stromführenden Leitungen eine Vorrichtung zur Stromermittlung (10) gemäß einem der Ansprüche 1 bis 10 aufweist, die eine Unterbrechung der zumindest einen stromführenden Leitung überbrückt oder in die zumindest eine stromführende Leitung integriert ist, wobei der Leistungswandler dazu eingerichtet ist, unter Verwendung einer mittels der Messkontakte (12) erfassten Spannungsdifferenz entlang des Widerstandsbereichs (11b) der Stromschiene (11, 14) einen im Betrieb des Leistungswandlers durch die stromführenden Leitungen fließenden Strom zu ermitteln, wobei der Leistungswandler auf eine Nennleistung ausgelegt ist, die größer als 10 kW, bevorzugt größer als 100 kW, besonders bevorzugt größer als 1000 kW ist.

12. Leistungswandler nach Anspruch 11, mit einer mehrkanaligen Vorrichtung (13) zur Stromermittlung, wobei die mehrkanalige Vorrichtung (13) eine Mehrkanal-Stromschiene (14) aufweist, wobei die Mehrkanal-Stromschiene (14) auf einer ersten Seite mindestens zwei individuelle Anschlussbereiche (11a) zum Anschluss mehrerer stromführender Leitungen und auf einer zweiten Seite eine gemeinsamen Sammelschiene (16) als gemeinsamen Anschlussbereich (11a) aufweist, wobei den individuellen Anschlussbereichen (11a) jeweils ein Widerstandsbereich (11b) zugeordnet ist, der zwischen dem jeweiligen individuellen Anschlussbereich (11a) und der Sammelschiene (16) angeordnet ist.

13. Leistungswandler nach Anspruch 12, wobei die Leiterplatte (20) zur Messwerterfassung planparallel zu der Stromschiene (14) angeordnet ist, wobei die Leiterplatte (20) mehrere Widerstandsbereiche (11b) überdeckt und mit den Messkontakten (12) mehrerer Widerstandsbereiche (11b) verbunden ist.

14. Leistungswandler nach Anspruch 13, wobei die Leiterplatte (20) eine Auswerteeinheit (18) zur Vorverarbeitung der gemessenen Spannungen und Temperaturen der einzelnen Widerstandsbereiche (11b) sowie eine galvanische Trennung (17) aufweist, wobei die Auswerteeinheit (18) über die galvanische Trennung (17) mit einer Steuereinheit des Leistungswandlers verbunden ist.

15. Leistungswandler nach einem der Ansprüche 12 bis 14, wobei die Leiterplatte (20) Schlitze (19) aufweist, die zwischen den Widerstandsbereichen (11b) angeordnet sind und sich parallel zur Längs-Mittelache (LA) von einem Rand der Leiterplatte (20) über mindestens die Hälfte der Länge der Leiterplatte (20) erstrecken.

## Claims

1. Apparatus for determining current (10) with a current busbar (11, 14), wherein the current busbar (11, 14) comprises connection regions (11a) and at least one resistance region (11b) arranged between the connection regions (11a) for measuring a direct and/or alternating current, in particular with currents greater than 100 amps, wherein the resistance region (11b) is essentially formed by a taper of the cross-section relative to the cross-section of the connection regions (11a) of the busbar (11, 14), wherein two measuring contacts (12) are arranged in the resistance region (11b), wherein the busbar (11, 14) has at least two recesses (4, 4a) in the resistance region (11b), which are arranged in the region of the measuring contacts (12) and are spaced apart from the measuring contacts (12) in the longitudinal direction, so that the regions of the measuring contacts (12) are essentially currentless during operation of the busbar (11, 14), wherein the busbar (11, 14) is formed in one piece and consists of copper or aluminium, and with a printed circuit board (2, 20) arranged in a plan-parallel manner with respect to the busbar (11, 14) for measured value acquisition, wherein the measured value acquisition comprises an acquisition of a voltage difference between the two measuring contacts (12) and an acquisition of the temperature of the resistance region (11b) via at least one temperature sensor (3).

2. Apparatus according to claim 1, wherein the taper is formed in particular by a reduction in the width of the resistance region (11b) to a value between 10 and 60 percent of the width of the connection region (11a) of the busbar (11, 14).

3. Apparatus according to claim 1 or 2, wherein the measuring contacts (12) are designed as press-fit pins which are pressed into press-fit holes in the busbar (11, 14).

4. Apparatus according to one of the preceding claims, wherein the measured value acquisition takes place via measuring lines (7a, 7b), which connect the measuring contacts (12) to a common tapping point (6) and are installed as conductor paths within the printed circuit board (2, 20) in such a way that frequency-dependent phase and amplitude measurement errors are reduced.

5. Apparatus according to Claim 4, wherein the measuring lines (7a, 7b) run in a plane of the printed circuit board (2, 20) which is arranged as the outermost inner layer of the guide plate (2, 20) on the side of the printed circuit board (2, 20) facing the resistance region (11b).

6. Apparatus according to Claims 4 or 5, wherein the measuring lines (7a, 7b) originate from the measuring contacts (12) and are brought together at the common tapping point (6) in such a way that the measuring lines (7a, 7b) are routed from at least one of the measuring contacts (12) of a resistance region (11b), running in two directions away from the measuring contact (12) to the edge of the resistance region (11b), and in particular run at least in part essentially symmetrically in relation to the longitudinal center axis (LA) and/or to the transverse center axis (QA) of the resistance region (11b).

7. Apparatus according to any one of Claims 4 to 6, wherein the measuring lines (7a, 7b) span an essentially closed measurement line region (8) which comprises, in one dimension, between 70 and 100 percent of the width of the resistance region (11b), and in the dimension perpendicular thereto comprises between 70 and 100 percent of the distance between the measuring contacts (12).

8. Apparatus according to any one of Claims 4 to 7, wherein the printed circuit board (2, 20) has a compensation structure (30), wherein the compensation structure (30) comprises a plurality of compensation paths (40a, 40b, 40c, 40d) which are arranged spatially parallel to one another, and can be connected electrically in series to one of the measuring lines (7a, 7b), wherein the compensation paths (40a, 40b, 40c, 40d) consist of conductor paths (31, 32, 33) in different planes of the printed circuit board (2, 20) and in each case span a surface which is oriented perpendicular to the busbar (11, 14) and parallel to the longitudinal center axis (LA).

9. Apparatus according to Claim 8, wherein the compensation paths (40a, 40b, 40c, 40d) each have two oppositely oriented compensation arms, wherein a compensation arm can be connected to the measuring line (7a, 7b) by each compensation path (40a, 40b, 40c, 40d).

10. Apparatus according to Claims 8 or 9, wherein the compensation paths (40a, 40b, 40c, 40d) are each bridged or connected to the measuring line (7a, 7b) by a fittable electrical connector (41).

11. Power converter comprising current-carrying lines for conducting the direct and/or alternating currents processed by the power converter, wherein at least one of the current-carrying lines comprises an apparatus for determining current (10) according to any one of Claims 1 to 10, which apparatus bridges an interruption of the at least one current-carrying line or is integrated into the at least one current-carrying line, wherein the power converter is designed to determine, using a voltage difference detected by means of the measuring contacts (12) along the resistance region (11b) of the busbar (11, 14), a current flowing through the current-carrying lines during operation of the power converter, wherein the power converter is designed to have a nominal power that is greater than 10 kW, preferably greater than 100 kW, particularly preferably greater than 1000 kW.

12. Power converter according to Claim 11, comprising a multi-channel apparatus (13) for determining current, wherein the multi-channel apparatus (13) comprises a multi-channel busbar (14), wherein the multi-channel busbar (14) has, on a first side, at least two individual connection regions (11a) for connecting a plurality of current-carrying lines and on a second side comprises a common busbar (16) as a common connection region (11a), wherein a resistance region (11b) which is arranged between the respective individual connection region (11a) and the common busbar (16) is associated in each case with the individual connection regions (11a).

13. Power converter according to Claim 12, wherein a printed circuit board (20) for detecting measurement values is arranged in a plane-parallel manner with respect to the busbar (14), wherein the printed circuit board (20) covers a plurality of resistance regions (11b) and is connected to the measuring contacts (12) of a plurality of resistance regions (11b).

14. Power converter according to Claim 13, wherein the printed circuit board (20) comprises an evaluation unit (18) for preprocessing the measured voltages and the temperatures of the individual resistance regions (11b), as well as a galvanic isolation (17), wherein the evaluation unit (18) is connected to a control unit of the power converter via the galvanic isolation (17).

15. Power converter according to any one of Claims 12 to 14, wherein the printed circuit board (20) has slots (19) arranged between the resistance regions (11b) and extending parallel to the longitudinal center axis (LA) from an edge of the printed circuit board (20) over at least half of the length of the printed circuit board (20).

## Revendications

1. Dispositif de détection de courant (10) comprenant une barre conductrice (11, 14), la barre conductrice (11, 14) des zones de raccordement (11a) et au moins une zone de résistance (11b) disposée entre les zones de raccordement (11a) pour mesurer un courant continu et/ou alternatif, en particulier avec des intensités de courant supérieures à 100 ampères, la zone de résistance (11b) étant essentiellement formée par un rétrécissement de la section transversale par rapport à la section transversale des zones de raccordement (11a) de la barre conductrice (11, 14), deux contacts de mesure (12) étant disposés dans la zone de résistance (11b), la barre conductrice (11, 14) présentant dans la zone de résistance (11b) au moins deux évidements (4, 4a) qui sont disposés dans la zone des contacts de mesure (12) et espacés dans le sens longitudinal des contacts de mesure (12), de sorte que les zones des contacts de mesure (12) sont essentiellement hors tension pendant le fonctionnement du rail conducteur (11, 14), le rail conducteur (11, 14) étant réalisé d'un seul tenant et étant constitué de cuivre ou d'aluminium, et avec une carte de circuit imprimé (2, 20) disposée parallèlement au rail conducteur (11, 14) pour l'acquisition des valeurs mesurées, l'acquisition des valeurs mesurées comprenant l'acquisition d'une différence de tension entre les deux contacts de mesure (12) et l'acquisition de la température de la zone de résistance (11b) via au moins un capteur de température (3).

2. Dispositif selon la revendication 1, dans lequel le rétrécissement est formé en particulier par une réduction de la largeur de la zone de résistance (11b) à une valeur comprise entre 10 et 60 % de la largeur des zones de raccordement (11a) du rail conducteur (11, 14).

3. Dispositif selon la revendication 1 ou 2, dans lequel les contacts de mesure (12) sont réalisés sous forme de broches enfoncées qui sont enfoncées dans des alésages enfoncés dans la barre conductrice (11, 14).

4. Dispositif selon l'une des revendications précédentes, dans lequel la saisie des valeurs mesurées s'effectue via des lignes de mesure (7a, 7b) qui relient les contacts de mesure (12) à un point de prélèvement commun (6) et sont disposées sous forme de pistes conductrices à l'intérieur de la carte de circuit imprimé (2, 20) de manière à réduire les erreurs de mesure de phase et d'amplitude dépendantes de la fréquence.

5. Dispositif selon la revendication 4, dans lequel les lignes de mesure (7a, 7b) s'étendent dans un plan de la carte de circuit imprimé (2, 20) qui est disposé comme couche intérieure la plus extérieure de la carte de circuit imprimé (2, 20) sur le côté de la carte de circuit imprimé (2, 20) tourné vers la zone de résistance (11b).

6. Dispositif selon la revendication 4 ou 5, dans lequel les lignes de mesure (7a, 7b) partent des contacts de mesure (12) et sont réunies au point de prélèvement commun (6) de telle sorte que les lignes de mesure (7a, 7b) partent d'au moins l'un des contacts de mesure (12) d'une zone de résistance (11b) dans deux directions à partir du contact de mesure (12) vers le bord de la zone de résistance (11b) et s'étendent en particulier au moins en partie de manière essentiellement symétrique par rapport à un axe longitudinal central (LA) et/ou à un axe transversal central (QA) de la zone de résistance (11b).

7. Dispositif selon l'une des revendications 4 à 6, dans lequel les lignes de mesure (7a, 7b) délimitent une zone de lignes de mesure (8) essentiellement fermée qui comprend, dans une dimension, entre 70 et 100 % de la largeur de la zone de résistance (11b) et, dans la dimension perpendiculaire à celle-ci, entre 70 et 100 % de la distance entre les contacts de mesure (12).

8. Dispositif selon l'une des revendications 4 à 7, dans lequel la carte de circuit imprimé (2, 20) comporte une structure de compensation (30), la structure de compensation (30) comportant plusieurs pistes de compensation (40a, 40b, 40c, 40d) qui sont disposées spatialement parallèlement les unes aux autres et peuvent être connectées électriquement en série à l'une des lignes de mesure (7a, 7b), les pistes de compensation (40a, 40b, 40c, 40d) sont constituées de pistes conductrices (31, 32, 33) situées à différents niveaux de la carte de circuit imprimé (2, 20) et s'étendent chacune sur une surface orientée perpendiculairement au rail conducteur (11, 14) et parallèlement à l'axe longitudinal central (LA).

9. Dispositif selon la revendication 8, dans lequel les pistes de compensation (40a, 40b, 40c, 40d) comportent chacune deux bras de compensation orientés en sens inverse, un bras de compensation pouvant être relié à la ligne de mesure (7a, 7b) à partir de chaque piste de compensation (40a, 40b, 40c, 40d) peut être relié à la ligne de mesure (7a, 7b).

10. Dispositif selon la revendication 8 ou 9, dans lequel les voies de compensation (40a, 40b, 40c, 40d) sont chacune pontées ou reliées à la ligne de mesure (7a, 7b) au moyen d'un connecteur électrique équipable (41).

11. Convertisseur de puissance avec des lignes conductrices de courant pour conduire les courants continus et/ou alternatifs traités par le convertisseur de puissance, au moins l'une des lignes conductrices de courant comportant un dispositif de détection de courant (10) selon l'une des revendications 1 à 10, qui shunte une interruption de la au moins une ligne conductrice de courant ou est intégré dans la au moins une ligne conductrice de courant, le convertisseur de puissance étant conçu pour déterminer, à l'aide d'une différence de tension détectée au moyen des contacts de mesure (12) le long de la zone de résistance (11b) de la barre conductrice (11, 14) pour déterminer un courant circulant dans les lignes conductrices de courant pendant le fonctionnement du convertisseur de puissance, le convertisseur de puissance étant conçu pour une puissance nominale supérieure à 10 kW, de préférence supérieure à 100 kW, et de manière particulièrement préférée supérieure à 1000 kW.

12. Convertisseur de puissance selon la revendication 11, avec un dispositif multicanaux (13) pour la détermination du courant, le dispositif multicanaux (13) présentant une barre omnibus multicanaux (14), la barre omnibus multicanaux (14) présentant, sur un premier côté, au moins deux zones de raccordement individuelles (11a) pour le raccordement de plusieurs lignes conductrices de courant et, sur un deuxième côté, un rail collecteur commun (16) comme zone de raccordement commune (11a), une zone de résistance (11b) étant associée à chacune des zones de raccordement individuelles (11a), laquelle zone de résistance est disposée entre la zone de raccordement individuelle respective (11a) et le rail collecteur (16).

13. Convertisseur de puissance selon la revendication 12, dans lequel la carte de circuit imprimé (20) est disposée de manière plane et parallèle à la barre omnibus multicanaux (14) pour l'acquisition des valeurs mesurées, la carte de circuit imprimé (20) recouvrant plusieurs zones de résistance (11b) et étant reliée aux contacts de mesure (12) de plusieurs zones de résistance (11b).

14. Convertisseur de puissance selon la revendication 13, dans lequel la carte de circuit imprimé (20) comporte une unité d'évaluation (18) pour le prétraitement des tensions et températures mesurées des différentes zones de résistance (11b) et une isolation galvanique (17), l'unité d'évaluation (18) étant reliée à une unité de commande du convertisseur de puissance via l'isolation galvanique (17).

15. Convertisseur de puissance selon l'une des revendications 12 à 14, dans lequel la carte de circuit imprimé (20) comporte des fentes (19) qui sont disposées entre les zones de résistance (11b) et s'étendent parallèlement à l'axe longitudinal médian (LA) depuis un bord de la carte de circuit imprimé (20) sur au moins la moitié de la longueur de la carte de circuit imprimé (20).
